# EUROPEAN PATENT SPECIFICATION

(11) **EP 4 629 245 B1**
(45) Date of publication and mention of the grant of the patent: **30.09.2026**
(21) Application number: 25163479.6
(22) Date of filing: 13.03.2025
(51) Int. Cl.: G11C 29/00, G11C 29/44

(54) **METHOD OF OPERATING NON-VOLATILE MEMORIES, CORRESPONDING DEVICE AND COMPUTER PROGRAM PRODUCT**
VERFAHREN ZUM BETRIEB NICHTFLÜCHTIGER SPEICHER, ZUGEHÖRIGE VORRICHTUNG UND COMPUTERPROGRAMMPRODUKT
PROCÉDÉ DE FONCTIONNEMENT DE MÉMOIRES NON VOLATILES, DISPOSITIF CORRESPONDANT ET PRODUIT DE PROGRAMME INFORMATIQUE

(30) Priority: 03.04.2024 IT 202400007324
(43) Date of publication of application: 08.10.2025
(73) Proprietor: STMicroelectronics International N.V., 1228 Plan-les-Ouates, Geneva (CH)
(72) Inventor: TOMAIUOLO, Francesco, 95024 Acireale (Catania) (IT); RUTA, Marco, 95027 San Gregorio di Catania (Catania) (IT); DE COSTANTINI, Diego, 96011 Augusta (Siracusa) (IT); GIBILARO, Marco Eugenio, 95021 Aci Castello (Catania) (IT); CONTE, Antonino, 95030 Tremestieri Etneo (Catania) (IT)
(74) Representative: Buzzi, Notaro & Antonielli d'Oulx S.p.A.

(56) References cited:
- US-A1- 2004 160 826
- US-A1- 2007 220 379
- US-A1- 2011 099 417
- US-B1- 9 490 034

## Description

### Technical field

The description relates to the field of data storage technologies.

One or more embodiments can be applied to computer storage technologies such as non-volatile memories (NVMs).

For instance, one or more embodiments can be applied to non-volatile Phase Change Memories currently referred to as PCM NVM or ePCM NVM.

### Background

Non-volatile memories, NVMs play a pivotal role in the field of digital storage, offering persistent data storage even in absence of power supply.

In fact, the evolution of NVM technologies has been instrumental in shaping the capabilities and efficiency of most of the electronic devices, ranging, for instance, from computers and smartphones to embedded systems and data centers.

For instance, Phase Change Memories, referred to as PCM, are a type of computer storage technology, and, generally, a non-volatile random-access storage technology that may be also embedded in integrated circuit (IC) semiconductor devices.

PCM operates on a bit-by-bit basis using an electric current that, by flowing through a heating material called phase-change material such as, for instance, a chalcogenide glass, melts and quenches such phase-change material, making it amorphous, or holds such phase-change material in its crystallization temperature range, thereby switching it to a crystalline state, such amorphous state being related to a low logic level of 1-bit of information and such crystalline state being related to a high logic level of such 1-bit of information.

Other examples of non-volatile memories can be ROMs (Read-Only Memories), flash memories, F-RAMs (Ferroelectric Random-Access Memories), MRAMs (Magnetoresistive Random-Access Memories), FeFET memories, RRAMmemories, or the like.

NVM memories can be affected by malfunctioning cells that arise during the manufacturing process or due to wear and tear over the memory's lifetime, potentially leading to unreliable or erroneous data storage.

To solve such a problem, NVM memories usually contain some redundancy, for instance, spare rows and/or columns used to replace faulty ones, aiming at maintaining the overall functionality of the memory device, that is, managing and mitigating defects or faults that may occur in memory cells.

Therefore, such a redundancy approach can be used in NVM in order to repair malfunctioning or faulty cells, substituting them with spare ones that are added in addition to the main array ones and used only in case of detection of such malfunctioning or faulty cells.

Different types of redundancy approaches can be considered, for instance, redundancy by row, column, sector, or others, depending on the type of defectivity that is to be repaired.

For example, a case of short between two adjacent columns can be repaired by substituting both "bad" columns with a pair of spare ones, that is, with a pair of redundancy columns.

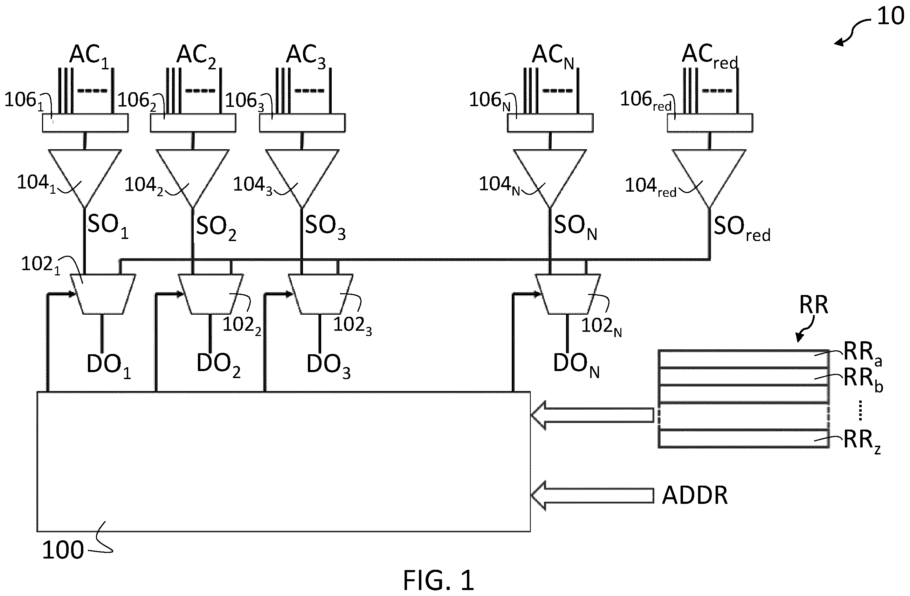

Figure 1 illustrates typical redundancy architecture 10 comprising an additional sense amplifier 104_{red}, that is, a redundancy sense amplifier.

The structure 10 of Figure 1 comprises a redundancy logic 100 configured to receive an address bus ADDR related to a memory section that is to be written/read, and a redundancy configuration bus indicating the bad memory sections that are to be replaced with spare memory sections.

Such redundancy configuration bus may be retrieved from a plurality of redundancy registers RR, comprising, for instance, a first redundancy register RRₐ, a second redundancy register RR_{b}, ..., and a last redundancy register RR_{z}.

The redundancy logic 100 is further configured to drive, via one or more selection commands, a plurality of multiplexers, collectively referred to as 102, comprising, for instance, a first multiplexer 102₁, a second multiplexer 102₂, a third multiplexer 102₃, ..., and an N-th multiplexer 102_{N}, in order to select either the main memory cells or the spare memory cells.

The plurality of multiplexers 102 may be coupled to a plurality of sense amplifiers, collectively referred to as 104, such plurality of sense amplifiers 104 comprising main sense amplifiers, for instance, a first sense amplifier 104₁, a second sense amplifier 104₂, a third sense amplifier 104₃, ..., and an N-th sense amplifier 104_{N}, and a redundancy sense amplifier 104_{red}.

Each multiplexer in the plurality of multiplexers 102 may be coupled, via a first terminal, to a respective main sense amplifier 104_{1-N} and, via a second terminal, to the redundancy sense amplifier 104_{red}, such multiplexer being configured to select either a main sense amplifier output signal SO_{1-N} at the first terminal (indicative of a selected main column) or a redundancy sense amplifier output signal SO_{red} at the second terminal (indicative of a selected spare column) based on a respective selection command sent from the redundancy logic 100 to the multiplexer.

Each multiplexer in the plurality of multiplexers 102 may be further configured to provide as output a respective data output signal DO_{1-N}, that is, either the main sense amplifier output signal SO_{1-N} or the redundancy sense amplifier output signal SO_{red}, based on the respective selection command received, such data output signal DO_{1-N} being indicative of a selected column (either a main column or a spare column).

The main sense amplifiers 104_{1-N} may be coupled between respective main column selectors, collectively referred to as 106_{1-N}, and respective multiplexers 102, and may be configured to provide a respective main sense amplifier output signal SO_{1-N} indicative of a selected main column to the respective coupled multiplexers 102.

Each of the main column selectors 106_{1-N} may be configured to select a main column in a plurality of main columns comprised in a respective main array of columns AC_{1-N} and to provide a signal indicative of the selected main column to a respective coupled main sense amplifier 104_{1-N}.

Similarly, the redundancy sense amplifier 104_{red} may be coupled between a redundancy column selector 106_{red} and respective multiplexers 102, and may be configured to provide the redundancy sense amplifier output signal SO_{red} indicative of a selected spare column to the coupled multiplexers 102.

The redundancy column selector 106_{red} may be configured to select a spare column in a plurality of spare columns comprised in a respective spare array of columns AC_{red} and to provide a signal indicative of the selected spare column to the coupled redundancy sense amplifier 104_{red}.

Therefore, the spare columns comprised in the spare array of columns AC_{red} can be addressed in parallel with the main columns comprised in one of the main arrays of columns AC_{1-N} and the spare column selected via the redundancy column selector 106_{red} can be read by the redundancy sense amplifier 104_{red}.

Hence, if a main column comprised in one of the main arrays of columns AC_{1-N} is bad, the redundancy logic 100 is configured to substitute, via the one or more selection commands, the output of the main sense amplifier 104_{1-N} coupled to the bad main column, that is, the main sense amplifier output signal SO_{1-N} related to the bad main column, with the output of the redundancy sense amplifier 104_{red}, that is, the redundancy sense amplifier output signal SO_{red}.

In addition, information related to bad columns can be stored in the redundancy registers RR, such redundancy registers RR being configured to store information related to addresses of bad columns and to numbers of the main sense amplifiers 104_{1-N} comprising such bad columns.

It is noted that the structure 10 of Figure 1 may comprise more than one redundancy sense amplifier 104_{red} and more than one redundancy column selector 106_{red} with a respective spare array of columns AC_{red}.

In such a case, if more than one redundancy sense amplifier 104_{red} is present, each multiplexer in the plurality of multiplexers 102 can be configured to receive, at its input terminals, every output SO_{red} provided by a redundancy sense amplifier of the more than one redundancy sense amplifiers 104_{red}.

It is noted that, in such a case, the output SOᵢ (with i ranging from 1 to N) of the main sense amplifier comprising a bad column is substituted with the output SO_{red} of one of the redundancy sense amplifiers 104_{red}, that is, the redundancy sense amplifier used to repair such bad column.

It is noted that the redundancy sense amplifier 104_{red} can be implemented considering the same architecture of the main sense amplifiers 104_{1-N}.

In addition, such redundancy sense amplifier 104_{red} can be coupled to a redundancy column selector 106_{red} related to a spare array of columns AC_{red} containing a number of spare columns equal to the number of main columns comprised in one of the main arrays of columns AC_{1-N}.

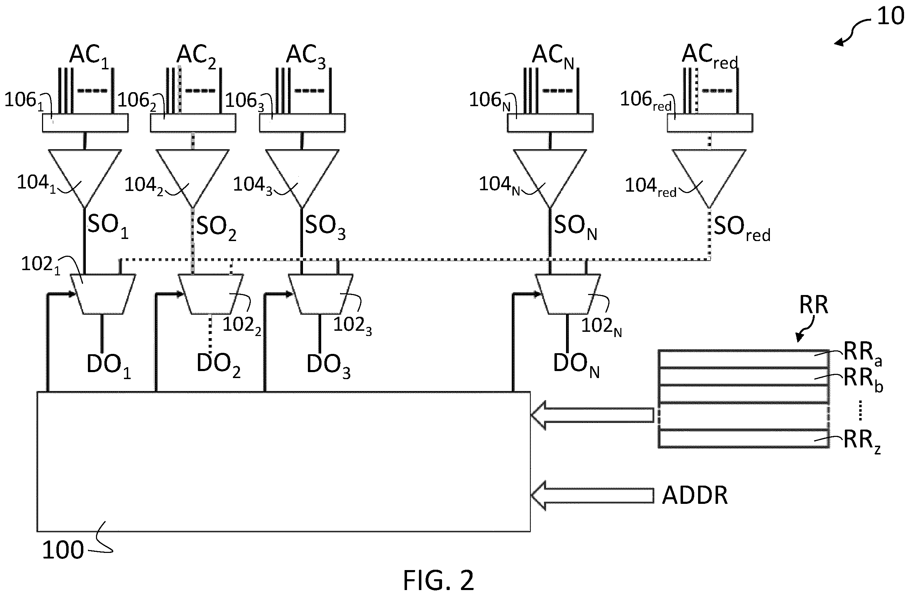

Figure 2 illustrates an exemplary bad main column substitution in typical redundancy architecture 10 of Figure 1.

It is noted that, in the Figures of the present application, bad main columns and corresponding bad signals are indicated with grey and black dashed lines, while spare columns that are used to replace such bad main columns and corresponding spare signals are indicated with white and black dashed lines.

Figure 2 illustrates a single bad main column substitution, where the bad main column that is to be substituted is the third main column comprised in a second main array of columns AC₂.

Therefore, such bad main column is substituted with the third spare column comprised in the spare array of columns AC_{red}.

It is noted that the bad main column that is to be substituted may also be any other main column, also one comprised in another main array of columns AC_{1-N}, in fact, the scenario reported in Figure 2 is only an exemplary scenario.

In such a case, the spare column that is considered for substituting the bad main column is the one in the position that corresponds to the considered bad main column.

Therefore, one of the redundancy registers RR may be configured to store information related to the address of the bad main column, that is, in the exemplary scenario of Figure 2, the third main column, and the number of the main sense amplifier 104_{1-N} comprising such bad main column, that is, in the exemplary scenario of Figure 2, the second main sense amplifier 104₂.

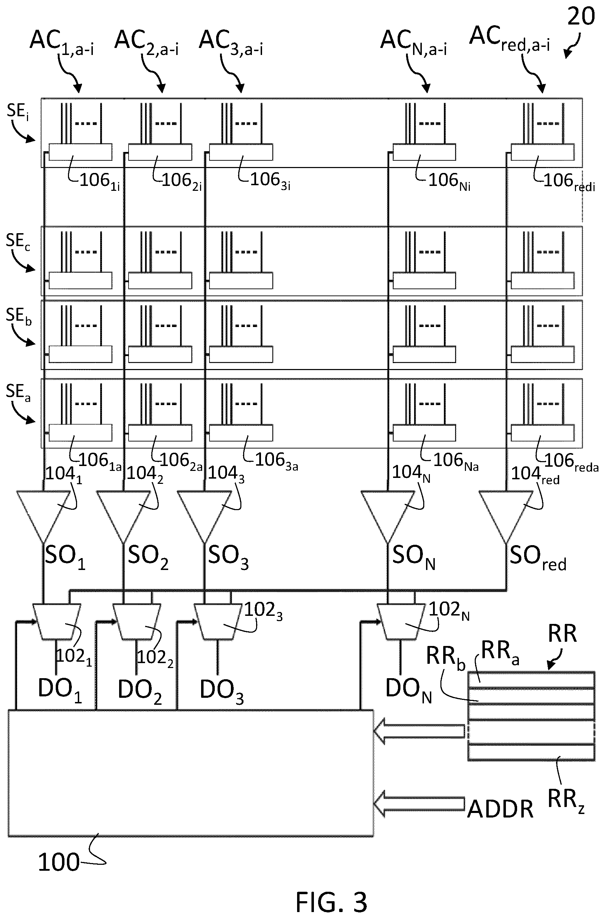

Figure 3 illustrates typical redundancy architecture 20 comprising a plurality of memory sectors, collectively referred to with the reference SE, for instance, comprising a first memory sector SEₐ, a second memory sector SE_{b}, a third memory sector SE_{c}, ..., and a last memory sector SEᵢ, and the additional sense amplifier 104_{red}, that is, the redundancy sense amplifier.

It is noted that parts, elements, and/or components illustrated in Figure 3 which have already been described with reference to Figure 1 are denoted by the same references previously used in such Figure. Therefore, the description of such previously described parts, elements, and/or components will not be repeated in the following in order not to overburden the present description.

In the structure 20 of Figure 3, each of the main sense amplifiers 104_{1-N} may be coupled between:
a plurality of main column selectors, comprising a first main column selector 106_{1-N,a}, a second main column selector 106_{1-N,b}, a third main column selector 106_{1-N,c}, ..., and a last main column selector 106_{1-N,i}, wherein each main column selector in the plurality of main column selectors is comprised in a different memory sector, and
a respective multiplexer 102.

Each of such main sense amplifiers 104_{1-N} may also be configured to provide to the respective coupled multiplexer 102 a respective main sense amplifier output signal SO_{1-N} indicative of a selected main column out of a plurality of main columns comprised in a main array of columns.

The main array of columns can be selected out of a plurality of main arrays of columns (comprising a first array of columns AC_{1-N,a}, a second array of columns AC_{1-N,b}, a third array of columns AC_{1-N,c}, ..., and a last array of columns AC_{1-N,i}) related to different main column selectors and respective different sectors.

Therefore, each of the main column selectors 106_{1-N,a-i} may be configured to select a main column out of a plurality of main columns comprised in a respective main array of columns AC_{1-N,a-i} and to provide a signal indicative of the selected main column to a respective coupled main sense amplifier 104_{1-N}.

Similarly, the redundancy sense amplifier 104_{red} may be coupled between:
a plurality of redundancy column selectors, collectively referred to with the reference 106_{reda-redi} and comprising a first redundancy column selector 106_{reda}, a second redundancy column selector 106_{redb}, a third redundancy column selector 106_{redc}, ..., and a last redundancy column selector 106_{redi}, wherein each redundancy column selector in the plurality of redundancy column selectors 106_{reda-redi} is comprised in a different memory sector, and
respective multiplexers 102.

Such redundancy sense amplifier 104_{red} may be configured to provide to the coupled multiplexers 102 the redundancy sense amplifier output signal SO_{red} indicative of a selected spare column out of a plurality of spare columns comprised in a spare array of columns.

The spare array of columns can be selected out of a plurality of spare arrays of columns AC_{red,a-i} (comprising a first array of columns AC_{red,a}, a second array of columns AC_{red,b}, a third array of columns AC_{red,c}, ..., and a last array of columns AC_{red,i}) related to different redundancy column selectors and respective different sectors.

Therefore, each redundancy column selector in the plurality of redundancy column selectors 106_{reda-redi} may be configured to select a spare column in a plurality of spare columns comprised in a respective spare array of columns AC_{red,a-i} and to provide a signal indicative of the selected spare column to the coupled redundancy sense amplifier 104_{red}.

It is noted that the spare columns comprised in one of the spare arrays of columns AC_{red,a-i} can be addressed in parallel with the main columns comprised in one of the main arrays of columns AC_{1-N,a-i}, and the selected spare column can be read via the redundancy sense amplifier 104_{red}.

Hence, if a main column comprised in one of the main arrays of columns AC_{1-N,a-i} is bad and to be substituted, the redundancy logic 100 is configured to substitute, via the one or more selection commands, the output of the main sense amplifier 104_{1-N} coupled to the bad main column, that is, the main sense amplifier output signal SO_{1-N} related to the bad main column, with the output of the redundancy sense amplifier 104_{red}, that is, the redundancy sense amplifier output signal SO_{red}.

In addition, information related to bad columns can be stored in the redundancy registers RR, such redundancy registers RR being configured to store information related to addresses of bad columns, to numbers of the main sense amplifiers 104_{1-N} comprising such bad columns, and to addresses of the sectors comprising such bad columns.

It is noted that the structure 20 of Figure 3 may comprise more than one redundancy sense amplifier 104_{red} and more than one plurality of redundancy column selectors 106_{reda-redi} with respective spare arrays of columns AC_{red,a-i}.

In such a case, if more than one redundancy sense amplifier 104_{red} is present, each multiplexer in the plurality of multiplexers 102 can be configured to receive, at its input terminals, every output SO_{red} provided by a redundancy sense amplifier of the more than one redundancy sense amplifiers 104_{red}.

It is noted that, in such a case, the output SOᵢ (with i ranging from 1 to N) of the main sense amplifier comprising a bad column is substituted with the output SO_{red} of one of the redundancy sense amplifiers 104_{red}, that is, the redundancy sense amplifier used to repair such bad column.

It is noted that the redundancy sense amplifier 104_{red} can be implemented considering the same architecture of the main sense amplifiers 104_{1-N}.

In addition, such plurality of redundancy column selectors 106_{reda-redi} can be related to respective spare arrays of columns AC_{red,a-i} containing a number of spare columns equal to the number of main columns comprised in one of the main arrays of columns AC_{1-N,a-i}.

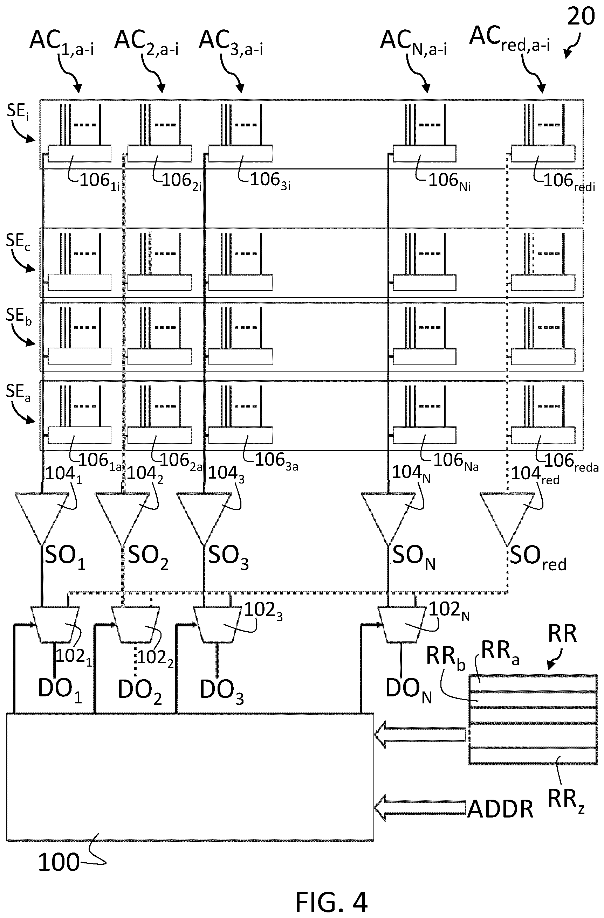

Figures 4 to 7 illustrate exemplary bad main column substitutions in typical redundancy architecture of Figure 3.

Figure 4 illustrates a single bad main column substitution, where the bad main column that is to be substituted is the third main column comprised in a second main array of columns of a third sector AC_{2,c}.

Therefore, such bad main column is substituted with the third spare column comprised in the spare array of columns of the third sector AC_{red,c}.

It is noted that the bad main column that is to be substituted may also be any other main column, also one comprised in another main array of columns, possibly in a different sector, AC_{1-N,a-i}, in fact, the scenario reported in Figure 4 is only an exemplary scenario.

In such a case, the spare column that is considered for substituting the bad main column is the one comprised in the same sector as the bad main column and placed in the position that corresponds to the considered bad main column.

Therefore, one of the redundancy registers RR may be configured to store information related to:
the address of the bad main column, that is, in the exemplary scenario of Figure 4, the third main column,
the number of the main sense amplifier 104_{1-N} comprising such bad main column, that is, in the exemplary scenario of Figure 4, the second main sense amplifier 104₂, and
the address of the sector of such bad main column, that is, in the exemplary scenario of Figure 4, the third sector referred to as SE_{c}.

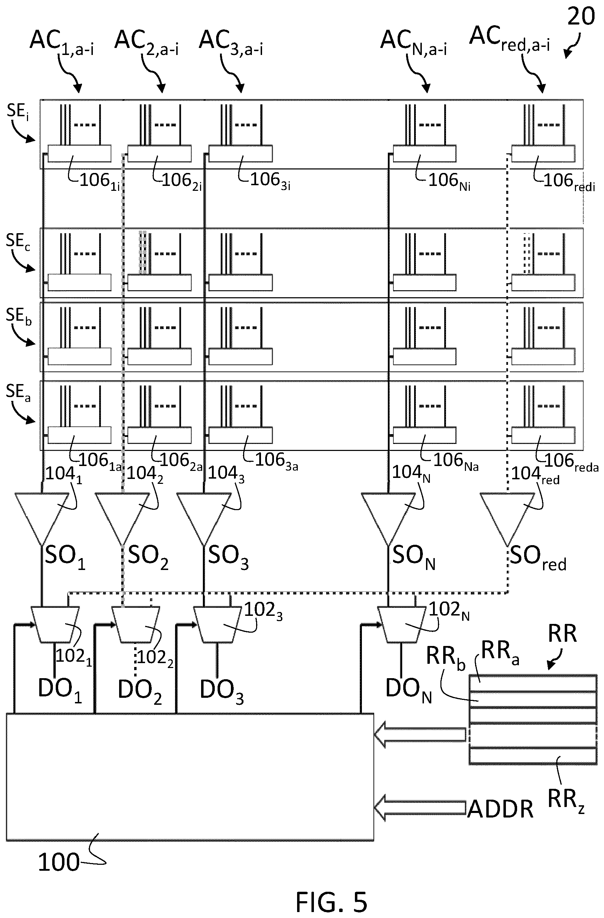

Figure 5 illustrates a couple of bad main columns substitution, where the couple of bad main columns that are to be substituted comprises the first and the second main columns comprised in a second main array of columns of a third sector AC_{2,c}.

For instance, a couple of bad main columns may arise in case of short between two main columns.

Therefore, such couple of bad main columns is substituted with a couple of spare columns, that is, the first and the second spare columns comprised in the spare array of columns of the third sector AC_{red,c}.

It is noted that the couple of bad main columns that are to be substituted may also be any other couple of main columns, also a couple comprised in another main array of columns, possibly in a different sector, AC_{1-N,a-i}, in fact, the scenario reported in Figure 5 is only an exemplary scenario.

In such a case, the couple of spare columns that are considered for substituting the couple of bad main columns is the couple comprised in the same sector as the couple of bad main columns and placed in the position that corresponds to the considered couple of bad main columns.

Therefore, one of the redundancy registers RR may be configured to store information related to:
the address of the couple of bad main columns, that is, in the exemplary scenario of Figure 5, the first and the second main columns,
the number of the main sense amplifier 104_{1-N} comprising such couple of bad main columns, that is, in the exemplary scenario of Figure 5, the second main sense amplifier 104₂, and
the address of the sector of such couple of bad main columns, that is, in the exemplary scenario of Figure 5, the third sector referred to as SE_{c}.

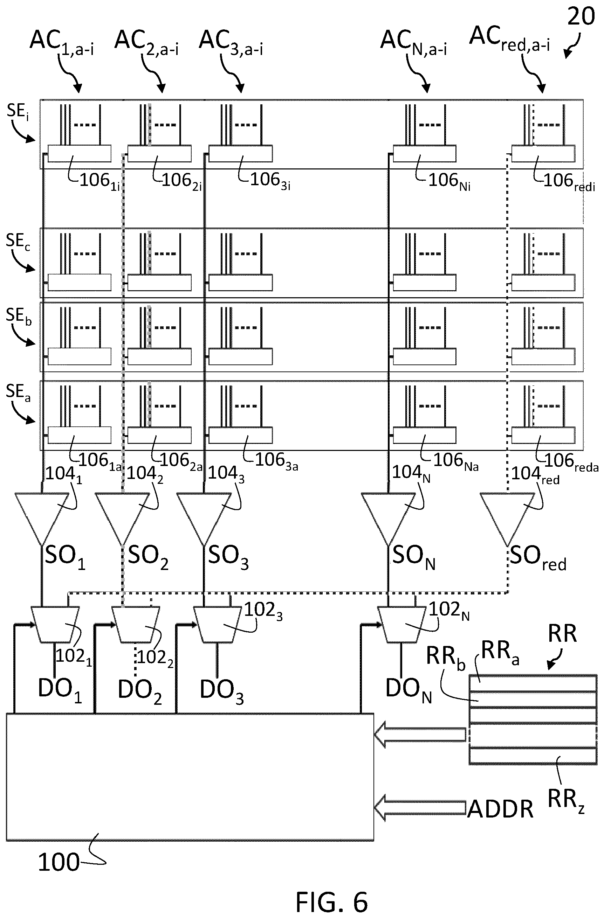

Figure 6 illustrates a single bad main column substitution for each of the sectors, such single bad main column that is to be substituted being placed in a same position in every sector.

For instance, in the exemplary scenario of Figure 6, the single bad main column that is to be substituted corresponds, in every sector, to the third main column comprised in the second main array of columns AC_{2,a-i}.

Therefore, such single bad main column is substituted, in every sector, with the third spare column comprised in the corresponding spare array of columns AC_{red,a-i}.

It is noted that the position in every sector of the single bad main column that is to be substituted may also be any other position, also a position in another main array of columns, AC_{1-N,a-i}, in fact, the scenario reported in Figure 6 is only an exemplary scenario.

In such a case, the spare column that is considered for substituting, in every sector, the single bad main column is the one placed in the position that corresponds to the considered single bad main column.

Therefore, one of the redundancy registers RR may be configured to store information related to:
the address of the single bad main columns, that is, in the exemplary scenario of Figure 6, the third main column, and
the number of the main sense amplifier 104_{1-N} comprising such single bad main columns, that is, in the exemplary scenario of Figure 6, the second main sense amplifier 104₂.

It is noted that such redundancy register does not comprise a sector address.

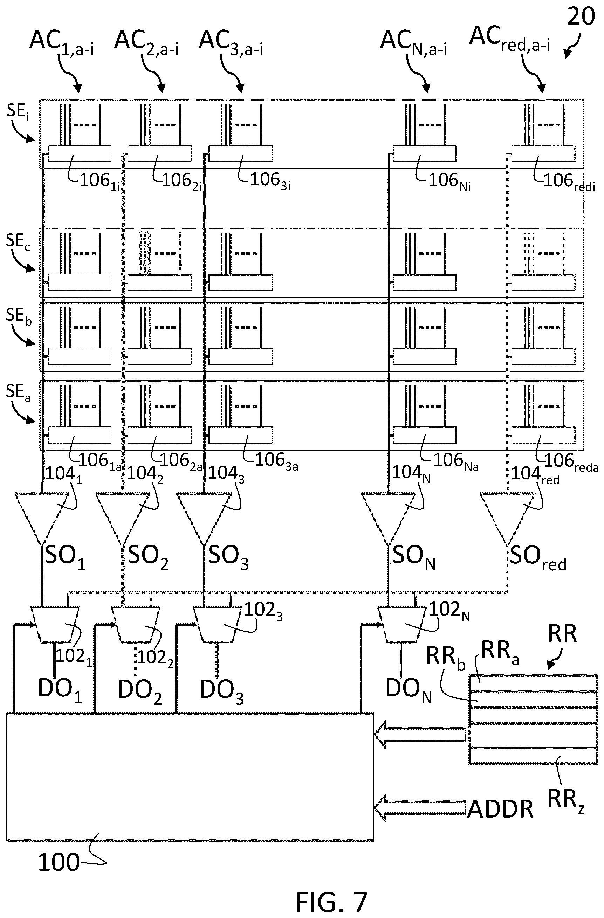

Figure 7 illustrates a main array of bad columns AC_{1-N,a-i} substitution, where the main array of bad columns that are to be substituted is the second main array of columns of the third sector AC_{2,c}.

Therefore, such main array of bad columns AC_{2,c} is substituted with the spare array of columns of the third sector AC_{red,c}.

It is noted that the main array of bad columns that is to be substituted may also be any other main array of columns, possibly in a different sector, AC_{1-N,a-i}, in fact, the scenario reported in Figure 7 is only an exemplary scenario.

In such a case, the spare array of columns that is considered for substituting the main array of bad columns is the one comprised in the same sector as the main array of bad columns.

Therefore, one of the redundancy registers RR may be configured to store information related to:
the number of the main sense amplifier 104_{1-N} coupled to such main array of bad columns, that is, in the exemplary scenario of Figure 7, the second main sense amplifier 104₂, and
the address of the sector of such main array of bad columns, that is, in the exemplary scenario of Figure 7, the third sector referred to as SE_{c}.

It is noted that such redundancy register does not comprise a bad main column address.

It is noted that also other scenario can be considered, for instance, substituting:
a main array of bad columns AC_{1-N,a-i} for each of the sectors, such main array of bad columns AC_{1-N,a-I} that is to be substituted being placed in a same position in every sector;
a group of four, eight, or others adjacent bad main columns comprised in a same sector;
a group of two, four, eight, or others adjacent bad main columns comprised in more than one sector;
a single bad bit comprised in any of the main columns;
a couple of bad bits comprised in any couple of adjacent main columns or in any couple of adjacent main rows;
a part of any of the main columns; or
similar substitutions.

It is noted that each of such substitutions have a different content of the redundancy registers RR, based on the address to be considered to identify the part to be substituted (column in only one sector, single bit, group of columns, or the like).

Known solutions have a fixed and hardcoded content of the redundancy registers RR.

Therefore, if the structures 10 and 20 and the corresponding redundancy registers RR are designed to substitute a given part of the array, for instance, a column, each of the redundancy registers RR can only substitute the same kind of part, that is, the given part designed to be substituted.

For example, if the given part that can be substituted is one column, each of the redundancy registers RR can be used to substitute one column.

In such a case, in case of short between two adjacent columns, two redundancy registers are used to substitute both columns.

In such a case, in case of short between four adjacent columns (that is, a cluster of columns), four redundancy registers are used to substitute such columns.

In general, the number of available redundancy registers RR limits the number of fails that can be repaired.

It is noted that if the kind of redundancy to be applied, that is, the considered given part that can be substituted, does not fit the kind of defectivity present on silicon, the malfunctioning or faulty cells related to such defectivity are considered loss and unusable.

Therefore, solutions that facilitate preventing the loss of malfunctioning or faulty cells in Non-Volatile Memories, NVMs, allowing to replace them with spare ones would be beneficial in order to increase the durability of such NVMs.

Documents US 2004/160826 A1, US 2011/099417 A1, US 9490034 B1, and US 2007/220379 A1 are exemplary of known solutions.

Document US 2004/160826 A1 discloses a memory device having a memory array and control circuitry to control operations to the memory array. A redundant register having a bit is also included. The bit is at a first level when two rows of the memory array are shorted together or at a second level when four rows of the memory array are shorted together. The control circuitry instructs an address counter, during an erase operation, to increment row addresses of the rows of the memory array by two rows when the bit is at the first level or four rows when the bit is at the second level.

Document US 2011/099417 A1 discloses a block repair device used in a Dynamic Random Access Memory (DRAM) having a primary array with a defective cell and a redundant array with a redundant row. The block repair device stores a block repair configuration that determines the dimensions (e.g., the number of rows and columns spanned) of a repair block. Routing circuitry is configured by the stored block repair configuration to output some row and column address bits from received row and column addresses in a selected ratio. Comparison circuitry compares the row and column address bits output by the routing circuitry with the address of the defective cell that defines the repair block. When a match occurs, the comparison circuitry implements a block repair by activating the redundant row and by causing data to be written to or read from the activated redundant row instead of the primary array.

Document US 9490034 B1 discloses a centralized redundancy block repair for memory circuits implemented in context of high-performance memory, such as last-level cache design, where the primary memory bank often uses high-density memory cells ("bitcells") and supports long self-bitline structures to increase compactness. In such contexts, it can be difficult to finish read operations within a single cycle, even when the entire cache is divided into small bank pieces. Bank-interleaved structure in clusters can be implemented to allow access to different memory banks in consecutive cycles, thereby achieving overall single circle throughput (i.e., the latency can be masked by the interleaving). The centralized block repair can support bank interleaved access, for example, with a strict single-cycle throughput. It can also support other features, such as row repair and/or column repair.

Document US 2007/220379 A1 discloses a method and apparatus for extracting sparse failure information from an error data image of a memory device by scanning the error data image in only two passes. During a first scan pass, the error data image is scanned for failures in a first set of memory cell groups organized along a first dimension, keeping track of failures seen in each of the respective memory cell groups in the first set, and keeping track of and designating as a must-repair memory cell group any memory cell group whose respective number of failures equals or exceeds a first maximum failure threshold. During a second scan pass, the error data image is scanned for failures in a second set of memory cell groups organized along a second dimension, keeping track of failures seen in each of the respective memory cell groups in the second set, and keeping track of and designating as a must-repair memory cell group any memory cell group whose respective number of failures equals or exceeds a second maximum failure threshold; and generating tag images containing only sparse failure information.

### Object and summary

An object of one or more embodiments is to contribute in providing such a solution. The invention is set out in the appended set of claims.

According to one or more embodiments, that object is achieved via a method of operating non-volatile memories having the features set forth in the claims that follow.

One or more embodiments concern a related device.

One or more embodiments concern a related computer program product loadable in at least one processing circuit (for instance, a computer) and comprising software code portions for executing the steps of the method when the product is run on at least one processing circuit.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein include a method of operating a non-volatile memory, NVM device, in response to a fault in at least one memory subsection in an addressable memory section of the NVM device.

The NVM device comprises also a spare memory section including spare memory subsections configured to substitute respective faulty memory subsections in the addressable memory section of the NVM device.

The method according to solutions as described herein comprises:
comparing addresses of memory subsections of the addressable memory section of the NVM device candidate for access with a set of faulty memory subsection addresses, the set including at least one address of a faulty memory subsection having coupled therewith a mask indicative of a related fault typology; and
substituting with a spare memory subsection in the spare memory section memory subsections of the addressable memory section candidate for access for which such comparing of addresses indicates a match by way of identity of the compared addresses or identity of the compared addresses having applied thereto address masking with such mask indicative of the related fault typology.

Solutions as described herein facilitate preventing a loss of malfunctioning or faulty cells in Non-Volatile Memories, NVMs, allowing to replace them with spare ones in order to increase the durability of such memories.

### Brief description of the figures

One or more embodiments will now be described, by way of example only, with reference to the annexed figures, wherein:
Figures 1 to 7 have been already discussed in the foregoing;
Figure 8 illustrates redundancy architecture comprising a redundancy sense amplifier according to embodiments of the present description;
Figures 9 and 10 illustrate exemplary bad main column substitutions in redundancy architecture of Figure 8 according to embodiments of the present description;
Figure 11 illustrates another redundancy architecture comprising a redundancy sense amplifier according to embodiments of the present description;
Figure 12 illustrates exemplary substitutions in redundancy architecture of Figure 11 according to embodiments of the present description;
Figure 13 illustrates redundancy architecture combining architectures of Figure 8 and Figure 11 according to embodiments of the present description; and
Figure 14 illustrates an exemplary implementation of a redundancy logic and of extended redundancy registers and (global) redundancy mode registers comprised in redundancy architecture of any of the Figures 8 to 13 according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As described in the above, solutions as disclosed herein aim at facilitating preventing a loss of malfunctioning or faulty cells in Non-Volatile Memories, NVMs, allowing to replace them with spare ones in order to increase the durability of such memories.

Solutions as described herein comprise a plurality of extended redundancy registers ERR comprising bits for addressing the non-volatile memory and configured to address, via such bits, a bad part of the non-volatile memory that is to be replaced with a spare one.

Solutions as described herein further comprise:
a "by die" redundancy mode register (also referred to as global redundancy mode register) GRMR configured to comprise information related to a kind of redundancy that is to be applied on a die in order to implement a "by die" approach, thus, allowing to decide die by die the kind of redundancy, that is, the part that can be substituted, to be applied on the die based on a defectivity, that is, a fault typology, of such die in order to recover from such defectivity; and/or
a plurality of redundancy mode registers RMR, for instance, comprising a redundancy mode register RMR for each of the extended redundancy registers ERR, configured to comprise information related to a kind of redundancy that is to be applied on the part of the non-volatile memory addressed by the respective extended redundancy register in order to implement a "by register" approach, thus, allowing to decide how to use each of the extended redundancy registers ERR independently, determining, for each of the extended redundancy registers ERR, a kind of redundancy based on a defectivity, that is, a fault typology, of the part of the non-volatile memory addressed by the respective extended redundancy register.

It is noted that even if the following description and the Figures related to the present solution are related to redundancy architectures comprising a plurality of memory sectors, collectively referred to with the reference SE, for instance, comprising a first memory sector SEₐ, a second memory sector SE_{b}, a third memory sector SE_{c}, ..., and a last memory sector SEᵢ, solutions as described herein may also apply to redundancy architectures comprising a single memory sector.

Solutions as described herein are related to a method of operating a non-volatile memory, NVM device, in response to a fault, for instance, one or more malfunctioning or faulty cells of the memory device having a related fault typology, for instance, column, couple of columns, bit, couple of adjacent bits on a same column, array, part of column, or the like, in at least one memory subsection in an addressable memory section, for instance, indicated with the reference AC_{1-N,a-i}, of the NVM device.

The NVM device comprises also a spare memory section, for instance, the memory section indicated with the reference AC_{red,a-i}, including spare memory subsections configured to substitute, for instance, via a redundancy sense amplifier 104_{red} and a plurality of multiplexers 102_{1-N}, respective faulty memory subsections in the addressable memory section AC_{1-N,a-i} of the NVM device.

The method described herein comprises:
comparing addresses of memory subsections, for instance, received via an address bus ADDR, of the addressable memory section AC_{1-N,a-i} of the NVM device candidate for access, for instance, to be read/written, with a set of faulty memory subsection addresses, for instance, one or more addresses comprised in respective extended redundancy registers of the plurality of extended redundancy registers ERR, the set including at least one address of a faulty memory subsection having coupled therewith a mask indicative of a related fault typology, for instance, one or more masks related to a kind of redundancy that is to be applied and comprised in the plurality of redundancy mode registers RMR and/or in the global redundancy mode register GRMR; and
substituting, for instance, via the redundancy sense amplifier 104_{red} and the plurality of multiplexers 102_{1-N}, with a spare memory subsection in the spare memory section AC_{red,a-i} memory subsections, addressed via the address bus ADDR, of the addressable memory section AC_{1-N,a-i} candidate for access for which such comparing of addresses indicates a match by way of identity of the compared addresses or identity of the compared addresses having applied thereto address masking with the mask indicative of the related fault typology.

It is noted that such method may comprise storing faulty memory addresses of the set of faulty memory subsection addresses in respective (extended) redundancy registers of the plurality of (extended) redundancy registers ERR.

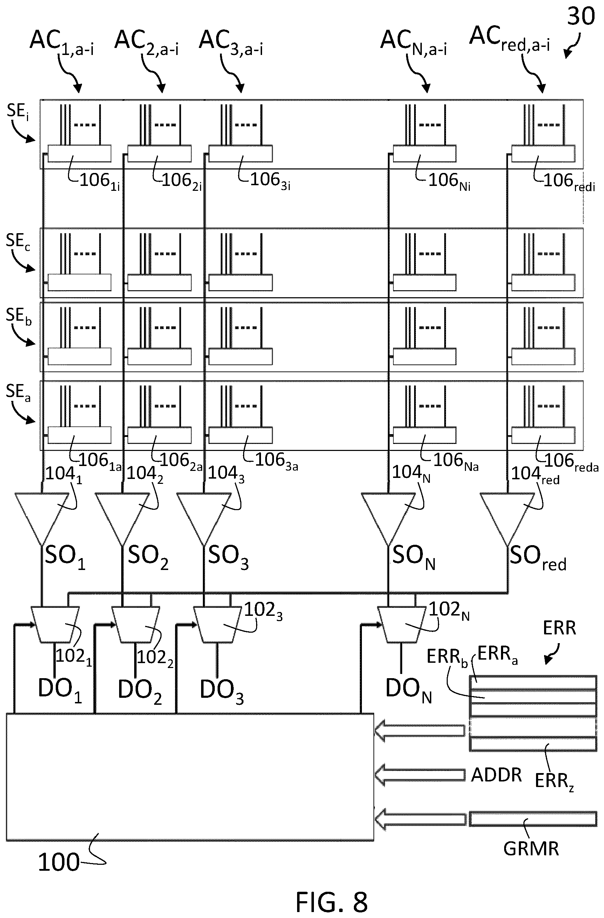

For instance, Figure 8 illustrates redundancy architecture 30 comprising a redundancy sense amplifier 104_{red} and implementing a "by die" approach according to embodiments of the present description.

The structure 30 of Figure 8 comprises a redundancy logic 100 configured to receive:
an address bus ADDR related to a memory section that is to be written/read, for instance, comprising an address of the memory section that is to be written/read,
a "by die" redundancy mode bus indicating the kind of redundancy that is to be applied on the die, and
an extended redundancy configuration bus indicating the bad memory sections that are to be replaced with spare memory ones.

Such "by die" redundancy mode bus may be retrieved from a "by die" redundancy mode register (also referred to as global redundancy mode register) GRMR configured to comprise information related to the kind of redundancy that is to be applied on the die, for instance, an address mask for masking part of the bits of the address bus ADDR in order to uniquely identify the kind of redundancy to be applied.

For example, if the column address is masked, the redundancy is applied to each column of a sector connected to the same sense amplifier.

For example, if the sector address is masked, the redundancy is applied to the same column in each sector.

In general, either the "by die" redundancy mode register GRMR considered in the "by die" approach or the plurality of redundancy mode registers RMR considered in the "by register" approach may contain the same number of bits of the address bus ADDR.

In such a case, each bit of a considered redundancy mode register (either GRMR or RMR) can be used, based on its content, to mask or not the correspondent bit of the address bus ADDR.

It is noted that if an address bit is masked, it is not considered in a comparison operation (described in the following) between the address bus ADDR and the content of a considered extended redundancy registers ERR.

It is noted that, even if the following description is focused on redundancy mode registers RMR or GRMR having a number of bits equal to that of the address bus ADDR, it is possible to consider different implementations with different number of bits.

For instance, other possible implementations may be configured to not apply a one-to-one association between the bits of the address bus ADDR and the masking bit comprised in the redundancy mode registers (either RMR or GRMR).

For example, it is possible to consider a redundancy mode register with less bits than the address bus ADDR.

In that case, each bit of the redundancy mode register can mask a group of bits of address bus ADDR.

For instance, a single bit of a considered redundancy mode register can mask the sector address (that is, all the bits of the address bus ADDR able to select the sector), another bit can mask the column address (that is, all the bits of the address bus ADDR able to select columns), or a couple of address bits (for instance, making selectable only the even/odd bits), or the like.

It is noted that also any other combination of the previous cases can be considered.

To summarize, in general, the number of bits of the redundancy mode registers RMR or GRMR is either equal or less than the number of bits of the address bus ADDR, therefore, each bit of a considered redundancy mode register can mask one or more bits of the address.

The extended redundancy configuration bus may be retrieved from a plurality of extended redundancy registers ERR, comprising, for instance, a first extended redundancy register ERRₐ, a second extended redundancy register ERR_{b}, ..., and a last extended redundancy register ERR_{z}.

Each extended redundancy register in the plurality of extended redundancy registers ERR can:
comprise bits for addressing the non-volatile memory, for instance, all the non-volatile memory or part of it (for instance, if the kind of redundancy can be applied on part of the non-volatile memory), and
be configured to address, via such bits, a bad part of the non-volatile memory that is to be replaced with a spare one.

The redundancy logic 100 is further configured to drive, via one or more selection commands, a plurality of multiplexers, collectively referred to as 102, comprising, for instance, a first multiplexer 102₁, a second multiplexer 102₂, a third multiplexer 102₃, ..., and an N-th multiplexer 102_{N}, in order to select either the main memory cells or the spare memory ones.

It is noted that such one or more selection commands can be generated based on the content of both the global redundancy mode register GRMR and the plurality of extended redundancy registers ERR.

Therefore, the redundancy logic 100 may be configured:
to compare the received address bus ADDR with the bad memory sections indicated by the extended redundancy configuration bus, that is, with the addresses of the bad memory sections; and
to substitute with a spare memory section the memory section addressed by the address bus ADDR if the comparison of the addresses indicates that the received address bus ADDR matches at least one address of a bad memory section by way of identity or by way of identity of the compared addresses having applied thereto a masking operation based on the kind of redundancy that is to be applied on the die, that is, based on a typology of the fault affecting the addressed bad memory section.

For instance, such comparison operation may comprise:
comparing the received address bus ADDR with the bad memory sections indicated by the extended redundancy configuration bus in order to obtain one or more comparison signals, for instance, one or more comparison addresses obtained by comparing the address comprised in the received address bus ADDR with the addresses related to the bad memory sections comprised in the extended redundancy registers ERR;
decoding the content of the global redundancy mode register GRMR in order to obtain information about the kind of redundancy that is to be applied on the die; and
determining, based on the comparison signal(s) and the information about the kind of redundancy that is to be applied on the die, if the memory section addressed by the address bus ADDR is related to one of the bad memory sections that are to be substituted, for instance, by masking the comparison addresses with the address mask comprised in the global redundancy mode register GRMR.

For instance, such substitution operation may comprise, if the memory section addressed by the address bus ADDR is related to one of the bad memory sections that are to be substituted, substituting the one of the bad memory sections related to the address bus ADDR with a spare memory section, for instance, by generating and applying the one or more selection commands to the plurality of multiplexers 102 indicating to one of such multiplexers 102 (the one related to the bad memory section addressed in the address bus ADDR) to select the output of the redundancy sense amplifier 104_{red}.

The plurality of multiplexers 102 may be coupled to a plurality of sense amplifiers, collectively referred to as 104, such plurality of sense amplifiers 104 comprising main sense amplifiers, for instance, a first sense amplifier 104₁, a second sense amplifier 104₂, a third sense amplifier 104₃, ..., and an N-th sense amplifier 104_{N}, and a redundancy sense amplifier 104_{red}.

Each multiplexer in the plurality of multiplexers 102 may be coupled, via a first terminal, to a respective main sense amplifier 104_{1-N} and, via a second terminal, to the redundancy sense amplifier 104_{red}, such multiplexer being configured to select either a main sense amplifier output signal SO_{1-N} at the first terminal (indicative of a selected main column) or a redundancy sense amplifier output signal SO_{red} at the second terminal (indicative of a selected spare column) based on a respective selection command sent from the redundancy logic 100 to the multiplexer.

For instance, if the redundancy logic 100 indicates, via the respective selection command, to select the output of the redundancy sense amplifier 104_{red}, the redundancy sense amplifier output signal SO_{red} at the second terminal is selected, otherwise, the main sense amplifier output signal SO_{1-N} is selected.

Each multiplexer in the plurality of multiplexers 102 may be further configured to provide as output a respective data output signal DO_{1-N}, that is, either the main sense amplifier output signal SO_{1-N} or the redundancy sense amplifier output signal SO_{red}, based on the respective selection command received, such data output signal DO_{1-N} being indicative of a selected column (either a main column or a spare column).

Each of the main sense amplifiers 104_{1-N} may be coupled between:
at least one main column selector 106 (for instance, in the exemplary structure 30 of Figure 8 is illustrated a plurality of main column selectors 106_{1-N,a-i}, but also a single main column selector 106_{1-N} can be considered); and
a respective multiplexer 102.

For instance, if a plurality of main column selectors 106_{1-N,a-i} is present as illustrated in Figure 8, such plurality of main column selectors can comprise a first main column selector 106_{1-N,a}, a second main column selector 106_{1-N,b}, a third main column selector 106_{1-N,c}, ..., and a last main column selector 106_{1-N,i}, and each main column selector in the plurality of main column selectors is comprised in a different memory sector.

Each of such main sense amplifiers 104_{1-N} may also be configured to provide a respective main sense amplifier output signal SO_{1-N} indicative of a selected main column to the respective coupled multiplexers 102.

For instance, if a single main column selector 106_{1-N} is present, such selected main column is selected out of a plurality of main columns comprised in a main array of columns selected via the single main column selector 106_{1-N}.

For instance, if a plurality of main column selectors 106_{1-N,a-i} is present as illustrated in Figure 8, such selected main column is selected out of a plurality of main columns comprised in a main array of columns, such main array of columns being selected out of a plurality of main arrays of columns (comprising a first array of columns AC_{1-N,a}, a second array of columns AC_{1-N,b}, a third array of columns AC_{1-N,c}, ..., and a last array of columns AC_{1-N,i}) related to different main column selectors and respective different sectors.

Therefore, each of the main column selectors 106 (either single main column selectors 106_{1-N} or pluralities of main column selectors 106_{1-N,a-i}) may be configured to select a main column out of a plurality of main columns comprised in a respective main array of columns (either the single main array of columns AC_{1-N} or the plurality of main arrays of columns AC_{1-N,a-i}) and to provide a signal indicative of the selected main column to a respective coupled main sense amplifier 104_{1-N}.

Similarly, the redundancy sense amplifier 104_{red} may be coupled between:
at least one redundancy column selector 106_{red} (for instance, in the exemplary structure 30 of Figure 8 is illustrated a plurality of redundancy column selectors 106_{reda-redi}, but also a single redundancy column selector 106_{red} can be considered); and
respective multiplexers 102.

For instance, if a plurality of redundancy column selectors 106_{reda-redi} is present as illustrated in Figure 8, such plurality of redundancy column selectors can comprise a first redundancy column selector 106_{reda}, a second redundancy column selector 106_{redb}, a third redundancy column selector 106_{redc}, ..., and a last redundancy column selector 106_{redi}, and each redundancy column selector in the plurality of redundancy column selectors is comprised in a different memory sector.

The redundancy sense amplifier 104_{red} may also be configured to provide the redundancy sense amplifier output signal SO_{red} indicative of a selected spare column to the coupled multiplexers 102.

For instance, if a single redundancy column selector 106_{red} is present, such selected spare column is selected out of a plurality of spare columns comprised in a spare array of columns AC_{red} selected via the single redundancy column selector 106_{red}.

For instance, if a plurality of redundancy column selectors 106_{reda-redi} is present as illustrated in Figure 8, such selected spare column is selected out of a plurality of spare columns comprised in a spare array of columns, such spare array of columns being selected out of a plurality of spare arrays of columns AC_{red,a-i} (comprising a first array of columns AC_{red,a}, a second array of columns AC_{red,b}, a third array of columns AC_{red,c}, ..., and a last array of columns AC_{red,i}) related to different redundancy column selectors and respective different sectors.

Therefore, each of the redundancy column selectors 106_{red} (either a single redundancy column selector 106_{red} or a plurality of redundancy column selectors 106_{red,a-i}) may be configured to select a spare column out of a plurality of spare columns comprised in a respective spare array of columns (either a single spare array of columns AC_{red} or a plurality of spare arrays of columns AC_{red,a-i}) and to provide a signal indicative of the selected spare column to the coupled redundancy sense amplifier 104_{red}.

It is noted that spare columns comprised either in the single spare array of columns AC_{red} or in the plurality of spare arrays of columns AC_{red,a-i} can be addressed in parallel with main columns comprised either in the single main array of columns AC_{1-N} or in the plurality of main arrays of columns AC_{1-N,a-i} respectively.

Then, the spare columns selected via the single redundancy column selector 106_{red} or the plurality of redundancy column selectors 106_{red,a-i} can be read by the redundancy sense amplifier 104_{red}.

Hence, if a main column comprised in one of the main arrays of columns AC_{1-N} or AC_{1-N,a-i} is bad and to be substituted, the redundancy logic 100 is configured to substitute, via the one or more selection commands, the output of the main sense amplifier 104_{1-N} coupled to the bad main column, that is, the main sense amplifier output signal SO_{1-N} related to the bad main column, with the output of the redundancy sense amplifier 104_{red}, that is, the redundancy sense amplifier output signal SO_{red}.

It is noted that the structure 30 of Figure 8 may comprise more than one redundancy sense amplifier 104_{red} and more than one redundancy column selector 106_{red} with a respective spare array of columns AC_{red} or more than one plurality of redundancy column selectors 106_{reda-redi} with respective pluralities of spare arrays of columns AC_{red,a-i}.

Again, in such a case, if more than one redundancy sense amplifier 104_{red} is present, each multiplexer in the plurality of multiplexers 102 can be configured to receive, at its input terminals, every output SO_{red} provided by a redundancy sense amplifier of the more than one redundancy sense amplifiers 104_{red}.

Again, it is noted that, in such a case, the output SOᵢ (with i ranging from 1 to N) of the main sense amplifier comprising a bad column is substituted with the output SO_{red} of one of the redundancy sense amplifiers 104_{red}, that is, the redundancy sense amplifier used to repair such bad column.

It is noted that the redundancy sense amplifier 104_{red} can be implemented considering the same architecture of the main sense amplifiers 104_{1-N}.

In addition, the redundancy column selectors 106_{red} or 106_{reda-redi} can be related to respective spare array of columns AC_{red} or AC_{red,a-i} containing a number of spare columns equal to the number of main columns comprised in one of the main arrays of columns AC_{1-N} or AC_{1-N,a-i}.

Therefore, the method described herein comprises storing such mask indicative of the related fault typology, that is, the information related to the kind of redundancy that is to be applied, in a memory (global) redundancy mode register GRMR, such fault typology being a fault typology of the addressable memory section AC_{1-N,a-i}, that is, a fault typology related to a kind of redundancy that is to be applied on the die.

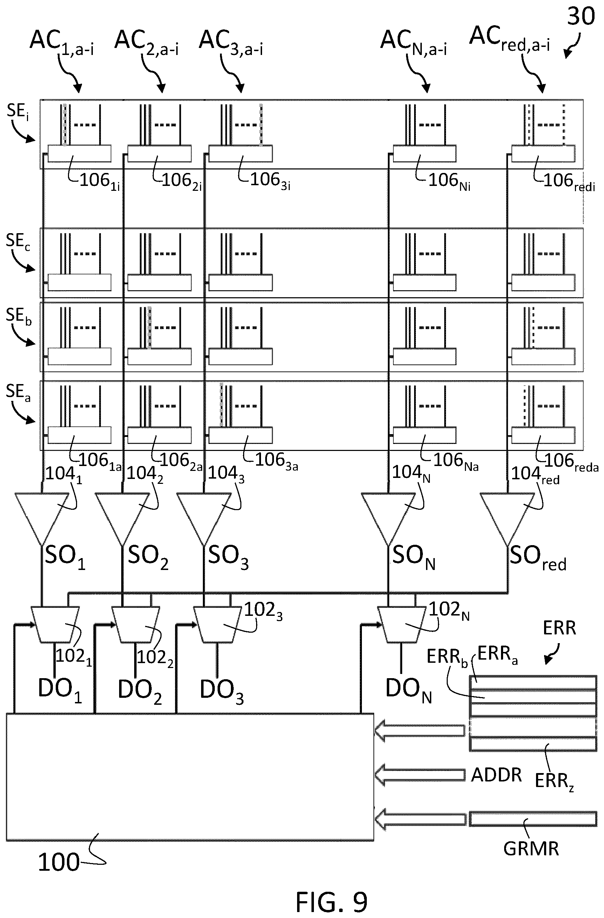

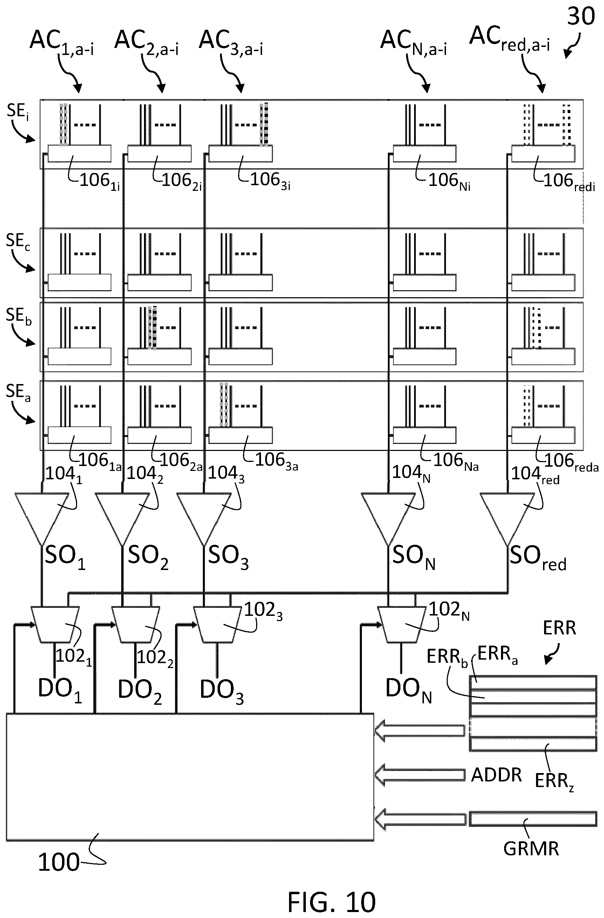

Figures 9 and 10 illustrate exemplary bad main column substitutions in redundancy architecture 30 of Figure 8 according to embodiments of the present description.

Figure 9 illustrates a "by die" approach selecting an exemplary "by column" substitution as the kind of redundancy to be applied on the die, that is, the part that can be substituted.

Therefore, in such a case, the global redundancy mode register GRMR is configured to comprise information indicating a "by column" redundancy as the kind of redundancy that is to be applied on the die, for instance, an address mask for masking a section of the memory address containing the row address in order to not consider the row address in the comparison operation between the address bus ADDR and the content of a considered extended redundancy registers ERR when using the "by column" kind of redundancy in a "by die" approach.

Hence, the redundancy logic 100, based on the content of the global redundancy mode register GRMR indicating a "by column" redundancy, is configured to generate the one or more selection commands based on only a part of the address bits comprised in the extended redundancy registers ERR and in the address bus ADDR, that is, only on the address bits that address columns and sectors, discarding the address bits related to rows.

In fact, the operation of determining performed by the redundancy logic 100, can, for instance, mask the comparison addresses, obtained by comparing the address bits comprised in the extended redundancy registers ERR with those comprised in the address bus ADDR, with the address mask comprised in the global redundancy mode register GRMR, thus, masking the address bits related to memory rows.

For instance, in Figure 9 the bad main columns that are to be substituted are single bad main columns corresponding to:
the second main column comprised in a first main array of columns of an i-th sector AC_{1,i};
the last main column comprised in a third main array of columns of the i-th sector AC_{3,i};
the third main column comprised in a second main array of columns of a second sector AC_{2,b}; and
the first main column comprised in a third main array of columns of the first sector AC_{3,a}.

Therefore, in the exemplary scenario of Figure 9, the plurality of extended redundancy registers ERR can be configured to address such bad main columns that are to be substituted.

Using the configuration described above, it is possible to substitute such single bad main columns with respective spare columns corresponding to:
the second spare column comprised in a spare array of columns of the i-th sector AC_{red,i};
the last spare column comprised in the spare array of columns of the i-th sector AC_{red,i};
the third spare column comprised in a spare array of columns of the second sector AC_{red,b}, and
the first spare column comprised in a spare array of columns of the first sector AC_{red,a}, respectively.

It is noted that the considered bad main columns may also be any other set of main columns, also comprising a different number of columns or columns comprised in other main arrays, possibly in different sectors, AC_{1-N,a-i}, in fact, the scenario reported in Figure 9 is only an exemplary scenario.

In such a case, the respective spare columns that are considered for substituting such bad main columns are those comprised in the same sector as the respective bad main column and placed in the position corresponding to such respective bad main column.

It is noted that, in the structure 30 of Figure 9, bad main columns located in a same position but in different main arrays of a same sector, for instance, the first main column comprised in the first main array of columns of the i-th sector AC_{1,i} and the first main column comprised in the second main array of columns of the i-th sector AC_{2,i}, cannot be substituted with respective spare columns since both the bad main columns are to be replaced with a same spare column, for instance, in the previous example, the first spare column comprised in the spare array of columns of the i-th sector AC_{red,i}.

It is noted that it is possible to solve the previous problem by considering more than one redundancy sense amplifier 104_{red} and more than one plurality of redundancy column selectors 106_{reda-redi} with respective pluralities of spare arrays of columns AC_{red,a-i}.

Figure 10 illustrates a "by die" approach selecting an exemplary "couple of columns" substitution as the kind of redundancy to be applied on the die, that is, the part that can be substituted.

Therefore, in such a case, the global redundancy mode register GRMR is configured to comprise information indicating a "couple of columns" redundancy as the kind of redundancy that is to be applied on the die, for instance, an address mask for masking a section of the memory address containing the row address and the less significant bit of the column address in order to not consider the row address and the less significant column address bit in the comparison operation between the address bus ADDR and the content of a considered extended redundancy registers ERR when using the "couple of columns" kind of redundancy in a "by die" approach.

Hence, the redundancy logic 100, based on the content of the global redundancy mode register GRMR indicating a "couple of columns" redundancy, is configured to generate the one or more selection commands based on only a part of the address bits comprised in the extended redundancy registers ERR and in the address bus ADDR, that is, only on the address bits that address couple of columns and sectors, discarding the address bits related to rows and the less significant bit of the column address.

In fact, the operation of determining performed by the redundancy logic 100, can, for instance, mask the comparison addresses, obtained by comparing the address bits comprised in the extended redundancy registers ERR with those comprised in the address bus ADDR, with the address mask comprised in the global redundancy mode register GRMR, thus, masking the address bits related to memory rows and the less significant bit of the column address.

For instance, in Figure 10 the couples of bad main columns that are to be substituted correspond to:
the first and the second main columns comprised in the first main array of columns of the i-th sector AC_{1,i};
the second-to-last and the last main columns comprised in the third main array of columns of the i-th sector AC_{3,i};
the third and the fourth main columns comprised in the second main array of columns of the second sector AC_{2,b}; and
the first and the second main columns comprised in the third main array of columns of the first sector AC_{3,a}.

Therefore, in the exemplary scenario of Figure 10, the plurality of extended redundancy registers ERR can be configured to address such couples of bad main columns that are to be substituted.

Using the configuration described above, it is possible to substitute such couples of bad main columns with respective couples of spare columns corresponding to:
the first and the second spare columns comprised in the spare array of columns of the i-th sector AC_{red,i};
the second-to-last and the last spare columns comprised in the spare array of columns of the i-th sector AC_{red,i};
the third and the fourth spare columns comprised in the spare array of columns of the second sector AC_{red,b}; and
the first and the second spare columns comprised in the spare array of columns of the first sector AC_{red,a}, respectively.

It is noted that the considered couples of bad main columns may also be any other set of couples of bad main columns, also comprising a different number of couples or couples comprised in other main arrays, possibly in different sectors, AC_{1-N,a-i}, in fact, the scenario reported in Figure 10 is only an exemplary scenario.

In such a case, the respective couples of spare columns that are considered for substituting such couples of bad main columns are those comprised in the same sector as the respective couple of bad main columns and placed in the position corresponding to such respective couple of bad main columns.

It is noted that, in the structure 30 of Figure 10, couples of bad main columns located in a same position but in different main arrays of a same sector, for instance, the first and the second main columns comprised in the first main array of columns of the i-th sector AC_{1,i} and the first and the second main columns comprised in the second main array of columns of the i-th sector AC_{2,i}, cannot be substituted with respective couples of spare columns since both the couples of bad main columns are to be replaced with a same couple of spare columns, for instance, in the previous example, the first and the second spare columns comprised in the spare array of columns of the i-th sector AC_{red,i}.

Again, it is noted that it is possible to solve the previous problem by considering more than one redundancy sense amplifier 104_{red} and more than one plurality of redundancy column selectors 106_{reda-redi} with respective pluralities of spare arrays of columns AC_{red,a-i}.

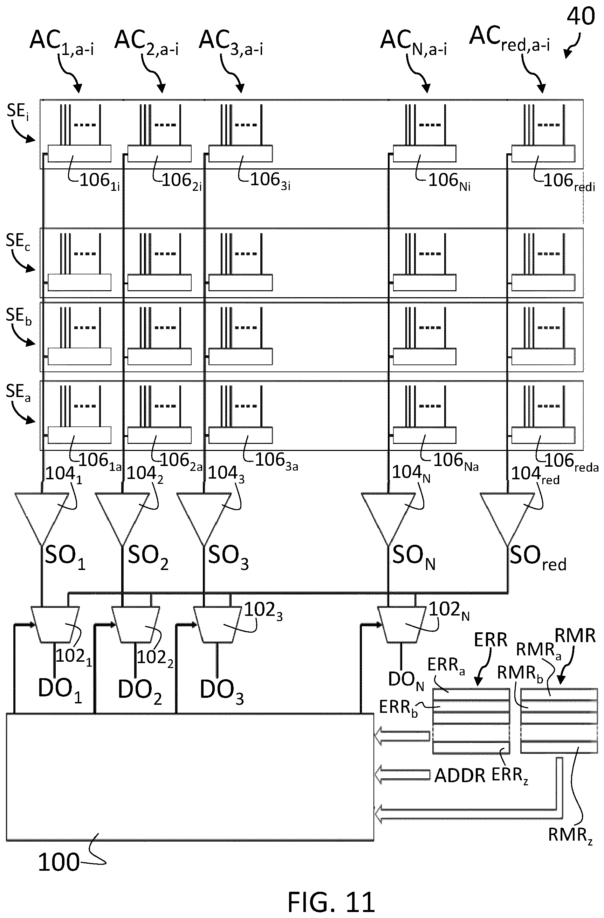

Figure 11 illustrates redundancy architecture 40 comprising a redundancy sense amplifier 104_{red} and implementing a "by register" approach according to embodiments of the present description.

The structure 40 of Figure 11 comprises a redundancy logic 100 configured to receive:
an address bus ADDR related to a memory section that is to be written/read, for instance, comprising an address of the memory section that is to be written/read, and
an extended redundancy configuration bus indicating the bad memory sections that are to be replaced with spare ones.

Such extended redundancy configuration bus may be retrieved from a plurality of extended redundancy registers ERR, comprising, for instance, a first extended redundancy register ERRₐ, a second extended redundancy register ERR_{b}, ..., and a last extended redundancy register ERR_{z}.

Each extended redundancy register in the plurality of extended redundancy registers ERR can:
comprise bits for addressing the non-volatile memory, for instance, all the non-volatile memory or part of it (for instance, if the kind of redundancy can be applied on part of the non-volatile memory), and
be configured to address, via such bits, a bad part of the non-volatile memory that is to be replaced with a spare one.

The redundancy logic 100 may be further configured to receive a "by register" redundancy mode bus indicating, for each extended redundancy register in the plurality of extended redundancy registers ERR, the kind of redundancy that is to be applied to a part of the non-volatile memory that is addressed by the considered extended redundancy register.

Such "by register" redundancy mode bus may be retrieved from a plurality of redundancy mode registers RMR, comprising, for instance, a first redundancy mode register RMRₐ, a second redundancy mode register RMR_{b}, ..., and a last redundancy mode register RMR_{z}.

Each of such redundancy mode registers RMR is related to a respective extended redundancy register and configured to comprise information regarding the kind of redundancy that is to be applied to the part of the non-volatile memory addressed by such respective extended redundancy register.

In general, the number of registers in the plurality of redundancy mode registers RMR can be either equal or smaller than the number of extended redundancy registers ERR.

If the number of registers in the plurality of redundancy mode registers RMR is equal to the number of extended redundancy registers ERR, there is a one-to-one association between the redundancy mode registers RMR and the extended redundancy registers ERR.

If the number of registers in the plurality of redundancy mode registers RMR is smaller than the number of extended redundancy registers ERR, each redundancy mode register RMR can be associated to a group of extended redundancy registers ERR.

In such a case, the selection of the kind of redundancy to be applied is done for a group of extended redundancy registers ERR.

For instance, each of such redundancy mode registers RMR can comprise an address mask for masking the bits of the address bus ADDR that are not considered in the comparison operation between such address bus ADDR and the content of a considered extended redundancy registers ERR when using the considered "by register" kind of redundancy related to such respective extended redundancy register.

Therefore, it is noted that a redundancy mode register RMR may be present for each extended redundancy register ERR, therefore, the number of registers in the plurality of redundancy mode registers RMR can be equal to the number of registers in the plurality of extended redundancy registers ERR.

Alternatively, the number of registers in the plurality of redundancy mode registers RMR may be smaller than the number of extended redundancy registers ERR, therefore, in such a case, one or more redundancy mode registers of the plurality of redundancy mode registers RMR can be associated to a group of extended redundancy registers ERR, that is, to more than one extended redundancy register ERR.

The redundancy logic 100 is further configured to drive, via one or more selection commands, a plurality of multiplexers 102 (as those already described in Figure 8) in order to select either the main memory cells or the spare memory ones, such one or more selection commands being generated based on the content of both the plurality of redundancy mode registers RMR and the plurality of extended redundancy registers ERR.

Therefore, the redundancy logic 100 is configured:
to compare the received address bus ADDR with the bad memory sections indicated by the extended redundancy configuration bus, that is, with the addresses of the bad memory sections; and
to substitute with a spare memory section the memory section addressed by the address bus ADDR if the comparison of the addresses indicates that the received address bus ADDR matches at least one address of a bad memory section by way of identity or by way of identity of the compared addresses having applied thereto a masking operation based on the kind of redundancy that is to be applied on the addressed part of the non-volatile memory, that is, based on a typology of the fault affecting the addressed bad memory section.

For instance, such comparison operation may comprise:
comparing the received address bus ADDR with the bad memory sections indicated by the extended redundancy configuration bus in order to obtain one or more comparison buses, for instance, one or more comparison address obtained by comparing the address comprised in the received address bus ADDR with the addresses related to the bad memory sections comprised in the extended redundancy registers ERR;
decoding the content of the plurality of redundancy mode registers RMR in order to obtain information about the kinds of redundancy that are to be applied to parts of the non-volatile memory addressed by the extended redundancy registers ERR; and
determining, based on the comparison bus(es) and the information about the kinds of redundancy that are to be applied on parts of the non-volatile memory addressed by such extended redundancy registers ERR, if the memory section addressed by the address bus ADDR is related to one of the bad memory sections that are to be substituted, for instance, by masking the comparison addresses with respective address masks comprised in the plurality of redundancy mode registers RMR.

For instance, such substitution operation may comprise, if the memory section addressed by the address bus ADDR is related to one of the bad memory sections that are to be substituted, substituting the one of the bad memory sections related to the address bus ADDR with a spare memory section, for instance, by generating and applying the one or more selection commands to the plurality of multiplexers 102 indicating to one of such multiplexers 102 (the one related to the bad memory section addressed in the address bus ADDR) to select the output of the redundancy sense amplifier 104_{red}.

It is noted that parts, elements, and/or components illustrated in Figure 11 which have already been described with reference to Figure 8 are denoted by the same references previously used in such Figure. Therefore, the description of such previously described parts, elements, and/or components will not be repeated in the following in order not to overburden the present description.

It is also noted that the observations and conclusions which have already been described with reference to Figure 8 can also be applied to the structure 40 of Figure 11, therefore, the description of such previously described observations and conclusions will not be repeated in the following in order to not overburden the present description.

Therefore, the method described herein comprises:
coupling (see Figures 11 to 13) to the (extended) redundancy registers in the plurality of (extended) redundancy registers ERR respective redundancy mode registers RMR, and
storing in the respective redundancy mode registers RMR respective masks indicative of a related fault typology, that is, the information regarding the kind of redundancy that is to be applied to the part of the non-volatile memory addressed by the coupled (extended) redundancy register;
wherein a faulty memory address and the mask indicative of the related fault typology coupled therewith are stored in a redundancy register ERR and in the respective redundancy mode register RMR coupled therewith, respectively.

It is noted that such method described herein may comprise:
coupling a set of (extended) redundancy registers in the plurality of (extended) redundancy registers ERR, that is, a set comprising more than one extended redundancy registers, to a same respective redundancy mode register RMR;
wherein a faulty memory address stored in a (extended) redundancy register ERR comprised in such set is coupled to a mask indicative of the related fault typology stored in said same respective redundancy mode register RMR.

In addition, it is noted that the respective masks indicative of a related fault typology may comprise at least one first mask indicative of a first related fault typology and at least one second mask indicative of a second related fault typology, wherein the first mask and the second mask are stored in a first redundancy mode register, for instance, the first redundancy mode register RMRₐ, and in a second redundancy mode register, for instance, the second redundancy mode register RMR_{b}, the first mask and the second mask being either equal or different therebetween.

For instance, the first mask may be equal to the second mask if the first related fault typology and the second related fault typology indicate a same fault typology.

For instance, the first mask may be different from the second mask if the first related fault typology and the second related fault typology indicate different fault typologies.

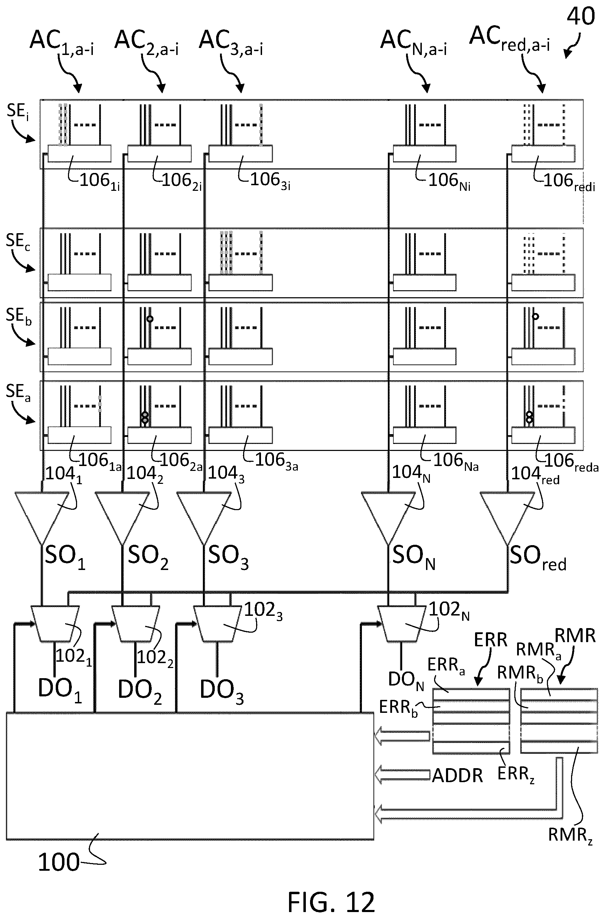

Figure 12 illustrates exemplary substitutions via a "by register" approach in redundancy architecture 40 of Figure 11 according to embodiments of the present description.

As previously described, the "by register" approach allow to apply a different kind of redundancy, selecting an array part to be substituted with a redundancy one, for each of the extended redundancy registers ERR independently.

The plurality of extended redundancy registers ERR can be configured to address the bad main section of the memory that are to be substituted.

Regarding the redundancy mode registers RMR, for instance, in the exemplary scenario of Figure 12:
a first redundancy mode register RMRₐ, related to a first extended redundancy register ERRₐ, can comprise information indicating a "by column" redundancy as the kind of redundancy to be applied, for instance, an address mask for masking a section of the memory address containing the row address in order to not consider the row address bits in the comparison operation between the address bus ADDR and the content of an extended redundancy register ERR when using the "by column" kind of redundancy of the first redundancy mode register RMRₐ;
a second redundancy mode register RMR_{b}, related to a second extended redundancy register ERR_{b}, can comprise information indicating a "couple of columns" redundancy as the kind of redundancy to be applied, for instance, an address mask for masking a section of the memory address containing the row address and the less significant bit of the column address in order to not consider the row address bits and the last significant column address bit in the comparison operation between the address bus ADDR and the content of an extended redundancy register ERR when using the "couple of columns" kind of redundancy of the second redundancy mode register RMR_{b};
a third redundancy mode register, related to a third extended redundancy register, can comprise information indicating a "by array" redundancy (that is, all the columns comprised in a same array of columns of a given sector) as the kind of redundancy to be applied, for instance, an address mask for masking a section of the memory address containing the row address and the column address in order to not consider the row address bits and the column address bits in the comparison operation between the address bus ADDR and the content of an extended redundancy register ERR when using the "by array" kind of redundancy of the third redundancy mode register;
a fourth redundancy mode register, related to a fourth extended redundancy register, can comprise information indicating a "by bit" redundancy (that is, related to a single bit) as the kind of redundancy to be applied, for instance, an address mask that does not mask any bit of the memory address in order to make each bit of the memory addressable for being replaced with spare one when using the "by bit" kind of redundancy of the fourth redundancy mode register;
a fifth redundancy mode register, related to a fifth extended redundancy register, can comprise information indicating a "by part of column" redundancy as the kind of redundancy to be applied, for instance, an address mask for masking sections of the memory address different from the one used to address considered parts of columns and sectors in order to not consider part of the row address bits in the comparison operation between the address bus ADDR and the content of an extended redundancy register ERR when using the "by part of column" kind of redundancy of the fifth redundancy mode register; and
a sixth redundancy mode register, related to a sixth extended redundancy register, can comprise information indicating a "couple of adjacent bits on a same column", for instance, considering a couple of adjacent bits, redundancy as the kind of redundancy to be applied, for instance, an address mask for masking only the less significant row address bit of the memory address in order to make each couple of bits of the memory addressable for being replaced with a spare couple when using the "couple of adjacent bits on a same column" kind of redundancy of the sixth redundancy mode register.

Hence, in the exemplary scenario of Figure 12, the redundancy logic 100, based on the content of the redundancy mode registers RMR indicating respective kinds of redundancy, is configured to generate the one or more selection commands based on only a part of the address bits comprised in the extended redundancy registers ERR and in the address bus ADDR, that is:
only on the address bits that address columns and sectors, discarding the address bits related to rows if the first redundancy mode register RMRₐ is considered;
only on the address bits that address couple of columns and sectors, discarding the address bits related to rows and the less significant bit of the column address if the second redundancy mode register RMR_{b} is considered;
only on the address bits that address sectors, discarding the address bits related to rows and columns if the third redundancy mode register is considered;
all the address bits if the fourth redundancy mode register is considered;
only on the address bits that address part of columns and sectors, discarding the other bits of the address if the fifth redundancy mode register is considered; and
all the address bits except for the less significant row address bit of the address if the sixth redundancy mode register is considered.

In fact, the operation of determining performed by the redundancy logic 100, can, for instance, mask the comparison addresses, obtained by comparing the address bits comprised in the extended redundancy registers ERR with those comprised in the address bus ADDR, with the address mask comprised in the considered redundancy mode register as described above.

For instance, in the exemplary scenario of Figure 12, such one or more selection commands are generated in order to substitute, respectively:
the last main column comprised in a third main array of columns of the i-th sector AC_{3,i} with the last spare column comprised in a spare array of columns of the i-th sector AC_{red,i}, based on the information comprised in the first redundancy mode register RMRₐ, that is, the "by column" redundancy, and the first extended redundancy register ERRₐ, that is, information related to addresses of bad main columns;
the first and the second main columns comprised in the first main array of columns of the i-th sector AC_{1,i} with the first and the second spare columns comprised in the spare array of columns of the i-th sector AC_{red,i}, based on the information comprised in the second redundancy mode register RMR_{b}, that is, the "couple of columns" redundancy, and the second extended redundancy register ERR_{b}, that is, information related to addresses of couples of bad main columns;
a third main array of columns of a third sector AC_{3,c} with a spare array of columns of the third sector AC_{red,c}, based on the information comprised in the third redundancy mode register, that is, the "by array" redundancy, and the third extended redundancy register, that is, information related to addresses of bad main arrays;
a single main bit comprised in the third main column of a second main array of a second sector AC_{2,b} with a single spare bit comprised in the third spare column of a spare array of the second sector AC_{red,b}, based on the information comprised in the fourth redundancy mode register, that is, the "by bit" redundancy, and the fourth extended redundancy register, that is, information related to addresses of bad single main bits;
a part of the last main column comprised in a first main array of columns of the first sector AC_{1,a} with a part of the last spare column comprised in a spare array of columns of the first sector AC_{rea,a}, based on the information comprised in the fifth redundancy mode register, that is, the "by part of column" redundancy, and the fifth extended redundancy register, that is, information related to addresses of parts of bad main columns; and
a couple of adjacent main bits comprised in the second main column of a second main array of a first sector AC_{2,a} with a couple of adjacent spare bits comprised in the second spare column of a spare array of the first sector AC_{red,a}, based on the information comprised in the sixth redundancy mode register, that is, the "couple of adjacent bits on a same column" redundancy, and the sixth extended redundancy register, that is, information related to addresses of bad couples of adjacent main bits.

It is noted that other kinds of redundancy may be considered, also in a different number, which can be substituted with respective parts, that is, parts in a same sector and in a same position, comprised in the spare memory section.

Therefore, bad memory sections located in a same position but in different main arrays of a same sector cannot be substituted with respective spare memory sections since both the bad memory sections are to be replaced with a same spare memory section.

Again, it is noted that it is possible to solve the previous problem by considering more than one redundancy sense amplifier 104_{red} and more than one plurality of redundancy column selectors 106_{reda-redi} with respective pluralities of spare arrays of columns AC_{red,a-i}.

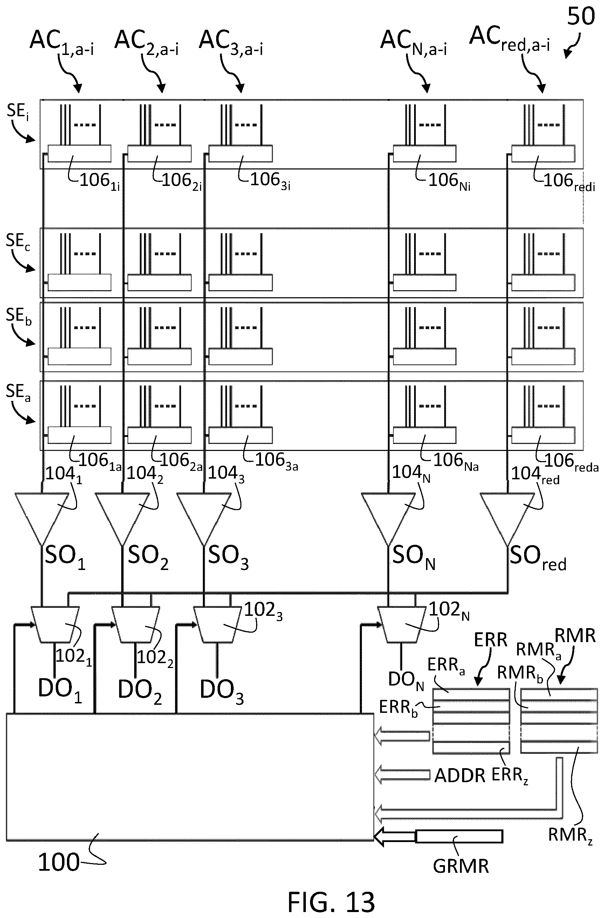

Figure 13 illustrates redundancy architecture 50 combining architectures 30 and 40 of Figures 8 and 11, thus, implementing a "by die" approach and a "by register" approach according to embodiments of the present description.

The structure 50 of Figure 13 comprises a redundancy logic 100 configured to receive:
an address bus ADDR related to a memory section that is to be written/read, for instance, comprising an address of the memory section that is to be written/read,
a "by die" redundancy mode bus indicating the kind of redundancy that can be applied on the die, and
an extended redundancy configuration bus indicating the bad memory sections that are to be replaced with spare ones.

Such "by die" redundancy mode bus may be retrieved from a "by die" redundancy mode register (also referred to as global redundancy mode register) GRMR configured to comprise information related to the kind of redundancy that can be applied on the die, for instance, an address mask for masking the bits of the address bus ADDR allowing to apply to the die the desired kind of redundancy, that is, the considered "by die" kind of redundancy.

The extended redundancy configuration bus may be retrieved from a plurality of extended redundancy registers ERR, comprising, for instance, a first extended redundancy register ERRₐ, a second extended redundancy register ERR_{b}, ..., and a last extended redundancy register ERR_{z}.

Each extended redundancy register in the plurality of extended redundancy registers ERR can:
comprise bits for addressing the non-volatile memory, for instance, all the non-volatile memory or part of it (for instance, if the kind of redundancy can be applied on part of the non-volatile memory), and
be configured to address, via such bits, a bad part of the non-volatile memory that is to be replaced with a spare one.

The redundancy logic 100 may be further configured to receive a "by register" redundancy mode bus indicating, for each extended redundancy register in the plurality of extended redundancy registers ERR, the kind of redundancy that is to be applied to a part of the non-volatile memory that is addressed by the considered extended redundancy register.

Such "by register" redundancy mode bus may be retrieved from a plurality of redundancy mode registers RMR, comprising, for instance, a first redundancy mode register RMRₐ, a second redundancy mode register RMR_{b}, ..., and a last redundancy mode register RMR_{z}.

Each of such redundancy mode registers RMR is related to a respective extended redundancy register and configured to comprise information regarding the kind of redundancy that is to be applied to the part of the non-volatile memory addressed by such respective extended redundancy register.

Therefore, for instance, each of such redundancy mode registers RMR can comprise an address mask for masking the bits of the address bus ADDR that are not considered in the comparison operation between the address bus ADDR and the content of an extended redundancy register ERR when using the considered "by register" kind of redundancy related to such respective extended redundancy register.

Therefore, it is noted that a redundancy mode register RMR is present for each extended redundancy register ERR, therefore, the number of registers in the plurality of redundancy mode registers RMR is equal to the number of registers in the plurality of extended redundancy registers ERR.

Alternatively, as previously described, the number of registers in the plurality of redundancy mode registers RMR may be smaller than the number of extended redundancy registers ERR, therefore, in such a case, one or more redundancy mode registers of the plurality of redundancy mode registers RMR can be associated to a group of extended redundancy registers ERR, that is, to more than one extended redundancy register ERR.

The redundancy logic 100 is further configured to drive, via one or more selection commands, a plurality of multiplexers 102 (as those already described in Figure 8) in order to select either the main memory cells or the spare memory ones, such one or more selection commands being generated based on the content of:
the plurality of redundancy mode registers RMR or the global redundancy mode register GRMR, depending on the approach that is to be used, and
the plurality of extended redundancy registers ERR.

Therefore, the redundancy logic 100 may be configured:
to compare the received address bus ADDR with the bad memory sections indicated by the extended redundancy configuration bus, that is, with the addresses of the bad memory sections; and
to substitute with a spare memory section the memory section addressed by the address bus ADDR if the comparison of the addresses indicates that the received address bus ADDR matches at least one address of a bad memory section by way of identity or by way of identity of the compared addresses having applied thereto a masking operation based on the kind of redundancy that is to be applied, that is, based on a typology of the fault affecting the addressed bad memory section.

For instance, such comparison operation may comprise:
comparing the received address bus ADDR with the bad memory sections indicated by the extended redundancy configuration bus in order to obtain one or more comparison buses, for instance, one or more comparison address obtained by comparing the address comprised in the received address bus ADDR with the addresses related to the bad memory sections comprised in the extended redundancy registers ERR;
receiving, for instance, via a binary control signal, indications related to the approach that is to be used, that is, either the "by die" approach or the "by register" approach;
if the "by die" approach is to be used, for instance, if the received binary control signal indicate to use a "by die" approach, decoding the content of the global redundancy mode register GRMR in order to obtain information about the kind of redundancy that is to be applied on the die, that is, a kind of redundancy signal;
if the "by register" approach is to be used, for instance, if the received binary control signal indicate to use a "by register" approach, decoding the content of the plurality of redundancy mode registers RMR in order to obtain information about the kinds of redundancy that are to be applied to parts of the non-volatile memory addressed by the extended redundancy registers ERR, that is, a kind of redundancy signal; and
determining, based on the comparison bus and the kind of redundancy signal, if the memory section addressed by the address bus ADDR is related to one of the bad memory sections that are to be substituted, for instance, by masking the comparison addresses with respective address masks comprised in the global redundancy mode register GRMR if a "by die" approach is considered or in the plurality of redundancy mode registers RMR if a "by register" approach is considered.

For instance, such substitution operation may comprise, if the memory section addressed by the address bus ADDR is related to one of the bad memory sections that are to be substituted, substituting the one of the bad memory sections related to the address bus ADDR with a spare memory section, for instance, by generating and applying the one or more selection commands to the plurality of multiplexers 102 indicating to one of such multiplexers 102 (the one related to the bad memory section addressed in the address bus ADDR) to select the output of the redundancy sense amplifier 104_{red}.

It is again noted that parts, elements, and/or components illustrated in Figure 13 which have already been described with reference to Figure 8 are denoted by the same references previously used in such Figure. Therefore, the description of such previously described parts, elements, and/or components will not be repeated in the following in order not to overburden the present description.

It is also noted that the observations and conclusions which have already been described with reference to Figure 8 can also be applied to the structure 50 of Figure 13, therefore, the description of such previously described observations and conclusions will not be repeated in the following in order to not overburden the present description.

Therefore, the method described herein may comprise:
reading the mask indicative of the related fault typology based on a received read control signal having one of a first value and a second value, for instance, indicating the approach that is to be used (that is, either the "by die" approach or the "by register" approach), respectively wherein the comparing comprises applying to the addresses compared:
the mask stored in the redundancy mode registers RMR in response to the received control signal having the first value, therefore, considering a "by register" approach; or
the mask stored in the memory (global) redundancy mode register GRMR in response to the received control signal having the second value, therefore, considering a "by die" approach.

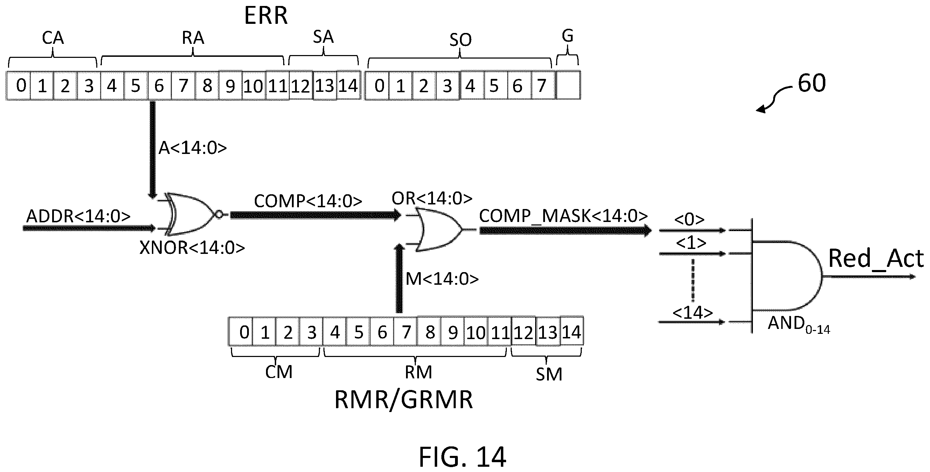

Figure 14 illustrates an exemplary implementation 60 of a redundancy logic 100 and of extended redundancy registers ERR and redundancy mode registers RMR and/or the global redundancy mode register GRMR comprised in the redundancy architecture 30, 40 or 50 according to any of the Figures 8 to 13 according to embodiments of the present description.

It is noted that the number of bits and the division of the registers reported in the following is described by way of example only, therefore, such details are not deemed as limiting the scope of protection of the present application.

For instance, an extended redundancy register ERR may comprise:
a set of address bits, for instance, comprising 15 bits in the exemplary implementation 60 of Figure 14, divided in column address bits CA, for instance, 4 bits, row address bits RA, for instance, 8 bits, and sector address bits SA, for instance 3 bits;
a set of main sense amplifier bits SO, for instance, comprising 8 bits in the exemplary implementation 60 of Figure 14, used to address (for instance, via a number of the main sense amplifier) a main sense amplifier 104 that is to be substituted with the redundancy sense amplifier 104_{red}; and
a guard bit, for instance, storing a high logic level (that is, "1") if the extended redundancy register is used or a low logic level (that is, "0") if the extended redundancy register is not used.

For instance, each of the redundancy mode registers RMR (if Figures 11 to 13 are considered) and the global redundancy mode register GRMR (if Figures 8 to 10 and 13 are considered) may comprise a set of address bits, for instance, comprising a number of bits equal to that of the extended redundancy registers ERR and same divisions.

Therefore, the set of address bits of the redundancy mode registers RMR and the global redundancy mode register GRMR may be divided in column address bits CM, row address bits RM, and sector address bits SM, for instance, comprising a number of bits equal to that of the corresponding section of the set of address bits comprised in the extended redundancy registers ERR.

Alternatively, as previously described, it is possible to consider redundancy mode registers (that is, either the "by die" redundancy mode register GRMR or the registers in the plurality of redundancy mode registers RMR) having less bits than the address bus ADDR and the extended redundancy registers ERR.

As previously described, in such a case, a bit comprised in a redundancy mode register RMR or GRMR can mask more than one bit of the address bus ADDR.

Therefore, for instance, each of the redundancy mode registers RMR (if Figures 11 to 13 are considered) and the global redundancy mode register GRMR (if Figures 8 to 10 and 13 are considered) may comprise a set of address bits, for instance, comprising a number of bits smaller than that of the extended redundancy registers ERR and divisions that can be either equal or different from those of the extended redundancy registers ERR.

Hence, the set of address bits of the redundancy mode registers RMR and the global redundancy mode register GRMR may be divided in column address bits CM, row address bits RM, and/or sector address bits SM, for instance, comprising a number of bits either equal to or lower than that of the corresponding section of the set of address bits comprised in the extended redundancy registers ERR.

It is noted that such an implementation is not illustrated in Figure 14, therefore, the following description will consider redundancy mode registers RMR and the global redundancy mode register GRMR having a set of address bits comprising a number of bits equal to that of the extended redundancy registers ERR and same divisions.

It is noted that an implementation considering a different number of bits as described above can be obtained by modifying Figure 14, changing the number of bits for each bit section of the redundancy mode registers RMR and the global redundancy mode register GRMR.

The exemplary implementation 60 illustrated in Figure 14 can be used to determine if a currently addressed main memory section is to be substituted with a spare one, considering also different kinds of redundancy (either "by die" if the register illustrated in Figure 14 is considered as the global redundancy mode register GRMR or "by register" if such register illustrated in Figure 14 is considered as a redundancy mode register RMR).

It is noted that such exemplary implementation 60 may be comprised, for instance, in the redundancy logic 100.

In addition, it is noted that such exemplary implementation 60 can be present, and is usually present, in the redundancy logic 100 more than one time, for instance, one time for each extended redundancy register ERR.

It is noted that such exemplary implementation 60 is described in the following by way of example only, therefore, such details are not deemed as limiting the scope of protection of the present application.

Figure 14 illustrates a XNOR gate XNOR<14:0> configured to receive at its input terminals the address bus ADDR, for instance, comprising a number of bits equal to that of the set of address bits of the extended redundancy registers ERR and same divisions ADDR<14:0>, and the extended redundancy configuration bus A<14:0> indicative of the set of address bits comprised in a considered extended redundancy register ERR.

The XNOR gate XNOR<14:0> is configured to compare the received buses bit-by-bit by applying a XNOR operation and to output a comparison bus COMP<14:0> that comprises bits set to a high logic level where the compared bits are equal and bits set to a low logic level where the compared bits are different.

Therefore, the method described herein may comprise, in the comparison operation:
checking, via a bit-by-bit equality, for instance, implemented via a XNOR gate, if the received addresses ADDR and the faulty memory addresses A, for instance, stored in extended redundancy registers ERR, in the set of faulty memory subsection addresses are equal, and
obtaining comparison addresses, for instance, comprised in the comparison bus COMP, comprising bits set to one logic level out of a high logic level and a low logic level, for instance, the high logic level, in correspondence of equal bits and bits set to the other logic level, for instance, the low logic level, in correspondence of different bits.

The comparison bus COMP<14:0> is received at one terminal of an OR gate OR<14:0>, such OR gate OR<14:0> being further configured to receive, at the other terminal, a redundancy mode bus M<14:0> that can be either:
a "by die" redundancy mode bus indicating the kind of redundancy that can be applied on the die, if the register illustrated in Figure 14 is considered as the global redundancy mode register GRMR; or
a "by register" redundancy mode bus indicating, for a respective extended redundancy register ERR, the kind of redundancy that can be applied on the memory section addressed by such respective extended redundancy register, if such register illustrated in Figure 14 is considered as a redundancy mode register RMR.

Such redundancy mode bus M<14:0> may be an address mask comprising bits set to a low logic level in correspondence of bits that are to be considered, that is, relevant bits, and bits set to a high logic level in correspondence of bits that are not to be considered, that is, bits that are to be masked.

For instance, if a "by bit" redundancy is considered, all the single bits of the set of address bits are relevant, that is, to be considered.

Therefore, the redundancy mode bus M<14:0> can be an address mask comprising bits set to a low logic level.

In such a case, in the exemplary implementation 60 of Figure 14, the redundancy mode bus M<14:0> can be equal to 0x0000 considering a hexadecimal notation.

For instance, if a "by column" redundancy is considered, bits addressing columns and sectors are relevant, that is, the bits to be considered are the column address bits CA and the sector address bits SA.

Therefore, the redundancy mode bus M<14:0> can be an address mask comprising bits set to a low logic level in correspondence of column address bits CA and sector address bits SA and bits set to a high logic level in correspondence of row address bits RA.

In such a case, in the exemplary implementation 60 of Figure 14, the redundancy mode bus M<14:0> can be equal to 0x0FF0 considering a hexadecimal notation, thus, masking the row address bits RA.

For instance, if a "couple of columns" redundancy is considered, bits addressing columns and sectors are relevant except for the less significant column address bit, that is, the bits to be considered are the column address bits CA except for the less significant bit and the sector address bits SA.

Therefore, the redundancy mode bus M<14:0> can be an address mask comprising bits set to a low logic level in correspondence of column address bits CA except for the less significant bit and sector address bits SA and bits set to a high logic level in correspondence of row address bits RA and the less significant bit of the column address bits CA.

In such a case, in the exemplary implementation 60 of Figure 14, the redundancy mode bus M<14:0> can be equal to 0x0FF1 considering a hexadecimal notation, thus, masking the row address bits RA and the less significant bit of the column address bits CA.

For instance, if a "by array" redundancy is considered, bits addressing sectors are relevant, that is, the bits to be considered are the sector address bits SA.

Therefore, the redundancy mode bus M<14:0> can be an address mask comprising bits set to a low logic level in correspondence of sector address bits SA and bits set to a high logic level in correspondence of column address bits CA and row address bits RA.

In such a case, in the exemplary implementation 60 of Figure 14, the redundancy mode bus M<14:0> can be equal to 0x0FFF considering a hexadecimal notation, thus, masking the column address bits CA and the row address bits RA.

It is noted that other types of redundancy can be considered in addition to those described herein simply by masking the desired bits by setting them to a high logic level and setting the relevant bits that are to be considered to a low logic level.

The OR gate OR<14:0> is configured to apply a bit-by-bit OR operation to the comparison bus COMP<14:0> and the redundancy mode bus M<14:0>, and to output a masked comparison bus COMP _MASK<14:0> that comprises bits set to a high logic level where the corresponding bits of the address bus ADDR and the extended redundancy configuration bus A<14:0> are equal or masked, and bit set to a low logic level where the corresponding bits of the address bus ADDR and the extended redundancy configuration bus A<14:0> are different and not masked.

The masked comparison bus COMP_MASK<14:0> is provided to an AND gate AND₀₋₁₄ configured to apply an AND operation to the bits of the received masked comparison bus COMP_MASK<14:0> and to set to a high logic level an output signal Red_Act if all the bits comprised in the masked comparison bus COMP_MASK<14:0> are set to a high logic level.

The output signal Red_Act is a signal indicating if a main memory section addressed by the address bus ADDR is to be substituted with a spare one.

If the output signal Red_Act is set to a high logic level, the main memory section addressed by the address bus ADDR is substituted with the corresponding spare memory section by enabling the redundancy sense amplifier 104_{red} and one of the corresponding redundancy column selectors 106_{red}.

Otherwise, if the output signal Red _Act is set to a low logic level, the main memory section addressed by the address bus ADDR is not substituted with a corresponding spare memory section, therefore, the redundancy sense amplifier 104_{red} and the corresponding redundancy column selectors 106_{red} are disabled.

It is noted that if the main memory section addressed by the address bus ADDR is substituted with the corresponding spare memory section, the information related to the address (that is, the number) of the main sense amplifier 104 that is to be substituted with the redundancy one 104_{red} is contained in the main sense amplifier bits SO of the considered extended redundancy register ERR.

In fact, the main sense amplifier bits SO contain, for instance, in binary, a number indicating which of the main sense amplifiers 104 is to be substituted with the redundancy one 104_{red}.

Therefore, the method described herein may comprise, in such comparison operation:
masking the comparison addresses, for instance, comprised in the comparison bus COMP, with respective masks indicative of fault typologies, for instance, comprised in the redundancy mode bus M, obtaining masked comparison addresses, for instance, comprised in the masked comparison bus COMP_MASK, wherein a masking operation considers as respective mask to be used the mask coupled to the faulty memory address used to obtain the comparison address that is to be masked;
checking if the bits of at least one masked comparison address COMP_MASK are set to the logic level corresponding to equal bits, for instance, in the exemplary scenario of Figure 14, to a high logic level; and
if the bits of at least one masked comparison address COMP_MASK are set to the logic level corresponding to equal bits, for instance, the high logic level, indicating a match, for instance, by setting to a high logic level the output signal Red_Act, between the received address ADDR and the faulty memory address A used to obtain such at least one masked comparison address COMP_MASK.

It is noted that such masking operation may comprise setting bits to be masked of the comparison addresses COMP to the logic level corresponding to equal bits, that is, to the high logic level.

Hence, the method as described herein may comprise, in the substitution operation:
reading, via a sense amplifier, for instance, the redundancy sense amplifier 104_{red}, configured to perform read operations in the spare memory section AC_{red,a-i}, spare memory subsections in the spare memory section AC_{red,a-i} that are configured to substitute the memory subsections, addressed via the address bus ADDR, of the addressable memory section AC_{1-N,a-i} candidate for access for which the comparison operation indicates the match, for instance, via the setting to a high logic level of an output signal Red_Act, between the received address, for example, comprised in the address bus ADDR, and a faulty memory address A, for example, comprised in an extended redundancy register ERR, in the set of faulty memory subsection addresses, obtaining a reading signal, for instance, the redundancy sense amplifier output signal SO_{red}; and
selecting, via a multiplexer, for instance, a multiplexer in the plurality of multiplexer 102_{1-N}, coupled to the spare memory subsections and the memory subsections, addressed via the address bus ADDR, of the addressable memory section candidate for access, the reading signal SO_{red}.

It is noted that if the main memory section addressed by the address bus ADDR, that is, the memory subsections of the addressable memory section candidate for access, is substituted with the corresponding spare memory section (that is, the spare memory subsections), the information related to the address (that is, the number) of the main sense amplifier 104 that is to be substituted with the redundancy one 104_{red} is contained in the main sense amplifier bits SO of the considered extended redundancy register ERR.

It is noted that if the extended redundancy configuration bus A<14:0> is equal to the address bus ADDR<14:0> (that is, a match by way of identity), all the bits of the comparison bus COMP<14:0> are already set to a high logic level, therefore, the masking operation performed by the OR gate OR<14:0> may not be required. In such a case, the comparison bus COMP<14:0> can be provided directly to the AND gate AND₀₋₁₄ that sets to a high logic level the output signal Red_Act.

Therefore, the method described herein may comprise, in the comparing operation of addresses of memory subsections addressed via the address bus ADDR of the addressable memory section AC_{1-N,a-i} of the NVM device candidate for access with the set of faulty memory subsection addresses, declaring a match, for instance, via the output signal Red_Act, by way of identity of the compared addresses in response to the addresses being compared exhibiting a bit-to-bit equality, for instance, in the example of Figure 14, having all the bits of the comparison bus COMP set to a high logic level.

It is also noted that the method described herein may comprise, in the comparing operation of addresses of memory subsections addressed via the address bus ADDR of the addressable memory section AC_{1-N,a-i} of the NVM device candidate for access with the set of faulty memory subsection addresses, declaring a match by way of identity of the compared addresses having applied thereto address masking with the mask indicative of the related fault typology, for instance, the bitmask M comprised in the redundancy mode registers RMR or in the global redundancy mode register GRMR, in response to the addresses being compared exhibiting bit-to-bit equality of the bits left unmasked by the mask, for instance, in response to the bits of the comparison bus COMP different from those that are masked using the mask M comprised in the redundancy mode registers RMR or in the global redundancy mode register GRMR (which are set, in the example of Figure 14, to a high logic level by the masking operation) being all set to, in the example of Figure 14, a high logic level (so that all the bits of the comparison bus - both the masked ones and the unmasked ones - are set to, in the example of Figure 14, to a high logic level, for instance, leading to the setting of the output signal Red_Act by the AND gate AND₀₋₁₄).

Solutions as described herein facilitate obtaining a method of operating a non-volatile memory, NVM device, in response to a fault (having a related fault typology) in at least one memory subsection in an addressable memory section of the NVM device.

The NVM device comprises also a spare memory section including spare memory subsections configured to substitute respective faulty memory subsections in the addressable memory section of the NVM device.

The method according to solutions as described herein comprises:
comparing addresses of memory subsections of the addressable memory section of the NVM device candidate for access with a set of faulty memory subsection addresses, the set including at least one address of a faulty memory subsection having coupled therewith a mask indicative of a related fault typology; and
substituting, using a spare memory subsection in the spare memory section, memory subsections of the addressable memory section candidate for access for which such comparing of addresses indicates a match by way of identity of the compared addresses or identity of the compared addresses having applied thereto address masking with the mask indicative of the related fault typology.

It is noted that the method described herein may be applied to non-volatile memory, NVM devices, such as Phase Change Memory, PCM devices.

It is noted that the method described herein may be applied also to other types of non-volatile memory, NVM devices.

It is noted that solutions as described herein may also refer to a non-volatile memory, NVM device, for instance, a Phase Change Memory device, the NVM device comprising an addressable memory section and a spare memory section including spare memory subsections configured to substitute respective faulty memory subsections in the addressable memory section of the NVM device, wherein the NVM device is configured to implement the method according to the present description.

It is noted that solutions as described herein also refer to a computer program product loadable in a control unit of a non-volatile memory, NVM device, for instance, a Phase Change Memory device, the NVM device comprising an addressable memory section and a spare memory section including spare memory subsections configured to substitute respective faulty memory subsections in the addressable memory section of the NVM device, wherein the computer program product comprises portions of software code configured to cause the NVM device to implement the method according to the present description in response to the computer program product being run in the control unit of the NVM device.

Thus, solutions as described herein facilitate preventing the loss of malfunctioning or faulty cells in Non-Volatile Memories, NVMs, by replacing them with spare ones, thus, increasing the durability of such memories.

Without prejudice to the underlying principles, the details and the embodiments may vary, even significantly, with respect to what has been described by way of example only.

The extent of protection is determined by the annexed claims.

## Claims

1. A method of operating a non-volatile memory, NVM device, in response to a fault in at least one memory subsection in an addressable memory section (AC_{1-N,a-i}) of the NVM device, wherein the NVM device comprises a spare memory section (AC_{red,a-i}) including spare memory subsections configured to substitute (104_{red}, 102_{1-N}) respective faulty memory subsections in the addressable memory section (AC_{1-N,a-i}) of the NVM device,
wherein the method comprises:
comparing addresses of memory subsections (ADDR) of the addressable memory section (AC_{1-N,a-i}) of the NVM device candidate for access with a set of faulty memory subsection addresses, the set including at least one address of a faulty memory subsection (A) having coupled therewith a mask (M) indicative of a related fault typology, said fault typology being related to the type of redundancy that is to be applied; and
substituting (104_{red}, 102_{1-N}) with a spare memory subsection in the spare memory section (AC_{red,a-i}) memory subsections (ADDR) of the addressable memory section (AC_{1-N,a-i}) candidate for access for which said comparing of addresses indicates a match (Red_Act) by way of identity of the compared addresses or identity of the compared addresses having applied thereto address masking with said mask (M) indicative of the related fault typology;
said method comprising storing faulty memory addresses (A) of the set of faulty memory subsection addresses in respective redundancy registers of a plurality of redundancy registers (ERR);
said method comprising:
coupling to the redundancy registers in the plurality of redundancy registers (ERR) respective redundancy mode registers (RMR), and
storing in the respective redundancy mode registers (RMR) respective masks (M) indicative of a related fault typology;
wherein a faulty memory address (A) and the mask (M) indicative of the related fault typology coupled therewith are stored in a redundancy register (ERR) and in the respective redundancy mode register (RMR) coupled therewith;
said method comprising storing said mask (M) indicative of the related fault typology in a memory redundancy mode register (GRMR), said fault typology being a fault typology of the addressable memory section (AC_{1-N,a-i});
said method comprising reading said mask (M) indicative of the related fault typology based on a received read control signal having one of a first value and a second value, respectively wherein said comparing comprises applying to the addresses compared:
the mask (M) stored in the redundancy mode registers (RMR) in response to the received control signal having said first value;
or
the mask (M) stored in the memory redundancy mode register (GRMR) in response to the received control signal having said second value.

2. The method according to claim 1, wherein a set of redundancy registers in the plurality of redundancy registers (ERR) is coupled to a same respective redundancy mode register (RMR);
wherein a faulty memory address (A) stored in a redundancy register (ERR) comprised in the set is coupled to a mask (M) indicative of the related fault typology stored in said same respective redundancy mode register (RMR).

3. The method according to claim 1 or claim 2, wherein said respective masks (M) indicative of a related fault typology comprise at least one first mask (M) indicative of a first related fault typology and at least one second mask (M) indicative of a second related fault typology, wherein the first mask (M) and the second mask (M) are stored in a first redundancy mode register (RMRₐ) and in a second redundancy mode register (RMR_{b}), the first mask (M) and the second mask (M) being either equal or different therebetween.

4. The method according to any of the previous claims, wherein said comparing of addresses of memory subsections (ADDR) of the addressable memory section (AC_{1-N,a-i}) of the NVM device candidate for access with said set of faulty memory subsection addresses comprises declaring a match (Red_Act) by way of identity of the compared addresses in response to the addresses being compared exhibiting a bit-to-bit equality (COMP).

5. The method according to any of the previous claims, wherein said comparing of addresses of memory subsections (ADDR) of the addressable memory section (AC_{1-N,a-i}) of the NVM device candidate for access with said set of faulty memory subsection addresses comprises declaring a match by way of identity of the compared addresses having applied thereto address masking with said mask (M) indicative of the related fault typology in response to the addresses being compared exhibiting bit-to-bit equality (COMP) of the bits left unmasked by said mask (M).

6. The method according to any of the previous claims, wherein said non-volatile memory, NVM device is a Phase Change Memory, PCM device.

7. A non-volatile memory, NVM device, preferably a Phase Change Memory device, the NVM device comprising an addressable memory section (AC_{1-N,a-i}) and a spare memory section (AC_{red,a-i}) including spare memory subsections configured to substitute (104_{red}, 102_{1-N}) respective faulty memory subsections in the addressable memory section (AC_{1-N,a-i}) of the NVM device;
wherein the device includes a redundancy logic (100) configured to compare addresses of memory subsections (ADDR) of the addressable memory section (AC1-N,a-i) of the NVM device candidate for access with a set of faulty memory subsection addresses and to substitute (104red, 1021-N) with a spare memory subsection in the spare memory section (ACred,a-i) memory subsections (ADDR) of the addressable memory section (AC_{1-N,a-i}) with the method according to any of the claims 1 to 6.

8. A computer program product loadable in a control unit of a non-volatile memory, NVM device, preferably a Phase Change Memory device, the NVM device comprising an addressable memory section (AC_{1-N,a-i}) and a spare memory section (AC_{red,a-i}) including spare memory subsections configured to substitute (104_{red}, 102_{1-N}) respective faulty memory subsections in the addressable memory section (AC_{1-N,a-i}) of the NVM device;
the computer program product comprising portions of software code configured to cause the NVM device to implement the method according to any of the claims 1 to 6 in response to the computer program product being run in the control unit of the NVM device.

## Patentansprüche

1. Verfahren zum Betrieb einer nichtflüchtigen Speichervorrichtung, NVM-Vorrichtung, als Reaktion auf einen Fehler in mindestens einem Speicherunterabschnitt in einem adressierbaren Speicherabschnitt (AC_{1-N,a-i}) der NVM-Vorrichtung, wobei die NVM-Vorrichtung einen Reservespeicherabschnitt (AC_{red,a-i}) umfasst, der Reservespeicherunterabschnitte enthält, die so konfiguriert sind, dass sie entsprechende fehlerhafte Speicherunterabschnitte im adressierbaren Speicherabschnitt (AC_{1-N,a-i}) der NVM-Vorrichtung ersetzen (104_{red}, 102₁₋ₙ),
wobei das Verfahren Folgendes umfasst:
Vergleichen von Adressen von Speicherunterabschnitten (ADDR) des adressierbaren Speicherabschnitts (AC_{1-N, a-i}) der für den Zugriff vorgesehenen NVM-Vorrichtung mit einem Satz fehlerhafter Speicherunterabschnittsadressen, wobei der Satz mindestens eine Adresse eines fehlerhaften Speicherunterabschnitts (A) enthält und damit eine Maske (M) gekoppelt ist, die auf eine zugehörige Fehlertypologie hinweist, wobei die Fehlertypologie mit der Art der anzuwendenden Redundanz in Zusammenhang steht; und
Ersetzen (104_{red,} 102_{1-N}) durch einen Reservespeicherunterabschnitt im Reservespeicherabschnitt (AC_{red,a-i}) von Speicherunterabschnitten (ADDR) des adressierbaren Speicherabschnitts (AC_{1-N,a-i}) als Kandidaten für den Zugriff, für die das Vergleichen von Adressen eine Übereinstimmung (Red_Act) anzeigt, anhand der Identität der verglichenen Adressen oder der Identität der verglichenen Adressen, die darauf eine Adressmaskierung mit der Maske (M) angewendet hat, die auf die zugehörige Fehlertypologie hinweist;
wobei das Verfahren das Speichern fehlerhafter Speicheradressen (A) des Satzes fehlerhafter Speicherunterabschnittsadressen in jeweiligen Redundanzregistern einer Vielzahl von Redundanzregistern (ERR) umfasst;
wobei das Verfahren umfasst:
Koppeln mit den Redundanzregistern in der Vielzahl von Redundanzregistern (ERR) bzw. Redundanzmodusregistern (RMR), und
Speichern in den jeweiligen Redundanzmodusregistern (RMR) entsprechender Masken (M), die auf eine zugehörige Fehlertypologie hinweisen;
wobei eine fehlerhafte Speicheradresse (A) und die Maske (M), die auf die damit gekoppelte zugehörige Fehlertypologie hinweist, in einem Redundanzregister (ERR) und in dem damit gekoppelten jeweiligen Redundanzmodusregister (RMR) gespeichert sind;
wobei das Verfahren das Speichern der Maske (M), die auf die zugehörige Fehlertypologie hinweist, in einem Speicherredundanzmodusregister (GRMR) umfasst, wobei die Fehlertypologie eine Fehlertypologie des adressierbaren Speicherabschnitts (AC_{1-N,a-i}) ist;
wobei das Verfahren das Lesen der Maske (M), die auf die zugehörige Fehlertypologie hinweist, basierend auf einem empfangenen Lese-Steuersignal mit einem ersten Wert und einem zweiten Wert umfasst, wobei das Vergleichen das Anwenden von Folgendem auf die verglichenen Adressen umfasst:
die in den Redundanzmodusregistern (RMR) gespeicherte Maske (M) als Reaktion auf das empfangene Steuersignal mit dem ersten Wert;
oder
die im Speicherredundanzmodusregister (GRMR) gespeicherte Maske (M) als Reaktion auf das empfangene Steuersignal mit dem zweiten Wert.

2. Verfahren nach Anspruch 1, wobei ein Satz von Redundanzregistern in der Vielzahl von Redundanzregistern (ERR) mit demselben jeweiligen Redundanzmodusregister (RMR) gekoppelt ist;
wobei eine fehlerhafte Speicheradresse (A), die in einem im Satz enthaltenen Redundanzregister (ERR) gespeichert ist, mit einer Maske (M) gekoppelt ist, die die zugehörige Fehlertypologie angibt, die in demselben jeweiligen Redundanzmodusregister (RMR) gespeichert ist.

3. Verfahren nach Anspruch 1 oder 2, wobei die jeweiligen Masken (M), die auf eine zugehörige Fehlertypologie hinweisen, mindestens eine erste Maske (M), die auf eine erste zugehörige Fehlertypologie hinweist, und mindestens eine zweite Maske (M), die auf eine zweite zugehörige Fehlertypologie hinweist, umfassen, wobei die erste Maske (M) und die zweite Maske (M) in einem ersten Redundanzmodusregister (RMRₐ) und in einem zweiten Redundanzmodusregister (RMR_{b}) gespeichert sind, wobei die erste Maske (M) und die zweite Maske (M) untereinander entweder gleich oder unterschiedlich sind.

4. Verfahren nach einem der vorhergehenden Ansprüche, wobei das Vergleichen von Adressen von Speicherunterabschnitten (ADDR) des adressierbaren Speicherabschnitts (AC_{1-N,a-i}) der für den Zugriff vorgesehenen NVM-Vorrichtung mit dem Satz fehlerhafter Speicherunterabschnittsadressen das Deklarieren einer Übereinstimmung (Red_Act) anhand der Identität der verglichenen Adressen als Reaktion darauf umfasst, dass die verglichenen Adressen eine Bit-für-Bit-Gleichheit (COMP) aufweisen.

5. Verfahren nach einem der vorhergehenden Ansprüche, wobei das Vergleichen von Adressen von Speicherunterabschnitten (ADDR) des adressierbaren Speicherabschnitts (AC_{1-N,a-i}) der für den Zugriff vorgesehenen NVM-Vorrichtung mit dem Satz fehlerhafter Speicherunterabschnittsadressen das Deklarieren einer Übereinstimmung anhand der Identität der verglichenen Adressen, auf die eine Adressmaskierung mit der Maske (M) angewendet wurde, die auf die zugehörige Fehlertypologie hinweist, als Reaktion darauf umfasst, dass die verglichenen Adressen eine Bit-für-Bit-Gleichheit (COMP) der durch die Maske (M) nicht maskierten Bits aufweisen.

6. Verfahren nach einem der vorhergehenden Ansprüche, wobei die nichtflüchtige Speichervorrichtung, NVM-Vorrichtung, eine Phasenwechselspeicher, PCM,-Vorrichung ist.

7. Nichtflüchtige Speichervorrichtung, NVM-Vorrichtung, vorzugsweise eine Phasenwechselspeichervorrichtung, wobei die NVM-Vorrichtung einen adressierbaren Speicherabschnitt (AC_{1-N,a-i}) und einen Reservespeicherabschnitt (AC_{red,a-i}) umfasst, der Reservespeicherunterabschnitte enthält, die so konfiguriert sind, dass sie jeweilige fehlerhafte Speicherunterabschnitte im adressierbaren Speicherabschnitt (AC_{1-N,a-i}) der NVM-Vorrichtung ersetzen (104_{red}, 102_{1-N});
wobei die Vorrichtung eine Redundanzlogik (100) enthält, die so konfiguriert ist, dass sie Adressen von Speicherunterabschnitten (ADDR) des adressierbaren Speicherabschnitts (AC_{1-N,a-i}) der für den Zugriff vorgesehenen NVM-Vorrichtung mit einem Satz fehlerhafter Speicherunterabschnittsadressen vergleicht und die Speicherunterabschnitte (ADDR) des adressierbaren Speicherabschnitts (AC1-N,a-i) nach dem Verfahren gemäß einem der Ansprüche 1 bis 6 durch einen Reservespeicherunterabschnitt im Reservespeicherabschnitt (AC_{red,a-i}) ersetzt (104_{red}, 102_{1-N}).

8. Computerprogrammprodukt, das in eine Steuereinheit einer nichtflüchtigen Speichervorrichtung, NVM-Vorrichtung, vorzugsweise einer Phasenwechselspeichervorrichtung, geladen werden kann, wobei die NVM-Vorrichtung einen adressierbaren Speicherabschnitt (AC_{1-N,a-i}) und einen Reservespeicherabschnitt (AC_{red,a-i}) umfasst, der Reservespeicherunterabschnitte enthält, die so konfiguriert sind, dass sie jeweilige fehlerhafte Speicherunterabschnitte im adressierbaren Speicherabschnitt (ACi_{1-N,a-i}) der NVM-Vorrichtung ersetzen (104_{red}, 102_{1-N});
wobei das Computerprogrammprodukt Abschnitte von Softwarecode umfasst, die so konfiguriert sind, dass sie die NVM-Vorrichtung dazu veranlassen, das Verfahren nach einem der Ansprüche 1 bis 6 als Reaktion auf das Computerprogrammprodukt, das in der Steuereinheit der NVM-Vorrichtung ausgeführt wird, umzusetzen.

## Revendications

1. Procédé de fonctionnement d'un dispositif de mémoire non volatile, ou MNV, en réponse à un défaut dans au moins une sous-section de mémoire dans une section de mémoire adressable (AC_{1-N,a-i}) du dispositif MNV, dans lequel le dispositif MNV comprend une section de mémoire de réserve (AC_{red,a-i}) comportant des sous-sections de mémoire de réserve configurées pour substituer (104_{red}, 102_{1-N}) des sous-sections de mémoire défectueuses respectives dans la section de mémoire adressable (AC_{1-N,a-i}) du dispositif MNV,
dans lequel le procédé comprend les étapes suivantes :
comparer des adresses de sous-sections de mémoire (ADDR) de la section de mémoire adressable (AC_{1-N,a-i}) du dispositif MNV candidates pour l'accès avec un ensemble d'adresses de sous-sections de mémoire défectueuses, l'ensemble comprenant au moins une adresse d'une sous-section de mémoire défectueuse (A) à laquelle est couplé un masque (M) indiquant une typologie de défaut liée, ladite typologie de défaut étant liée au type de redondance qui doit être appliqué ; et
substituer (104_{red}, 102_{1-N}) avec une sous-section de mémoire de réserve de la section de mémoire de réserve (AC_{red,a-i}) des sous-sections de mémoire (ADDR) de la section de mémoire adressable (AC_{1-N,a-i}) candidates pour l'accès pour lesquelles ladite comparaison d'adresses indique une correspondance (Red_Act) grâce à l'identité des adresses comparées ou à l'identité des adresses comparées auxquelles on a appliqué un masquage d'adresse avec ledit masque (M) indiquant la typologie de défaut liée ;
ledit procédé comprenant le fait de stocker les adresses de mémoire défectueuses (A) de l'ensemble d'adresses de sous-sections de mémoire défectueuses dans des registres de redondance respectifs d'une pluralité de registres de redondance (ERR) ;
ledit procédé comprenant les étapes suivantes :
coupler aux registres de redondance de la pluralité de registres de redondance (ERR) des registres de mode de redondance respectifs (RMR), et
stocker dans les registres de mode de redondance respectifs (RMR) des masques respectifs (M) indiquant une typologie de défaut liée ;
dans lequel une adresse de mémoire défectueuse (A) et le masque (M) indiquant la typologie de défaut liée couplé à celle-ci sont stockés dans un registre de redondance (ERR) et dans le registre de mode de redondance respectif (RMR) couplé à celui-ci ;
ledit procédé comprenant le fait de stocker ledit masque (M) indiquant la typologie de défaut liée dans un registre de mode de redondance de mémoire (GRMR), ladite typologie de défaut étant une typologie de défaut de la section de mémoire adressable (AC_{1-N,a-i}) ;
ledit procédé comprenant le fait de lire ledit masque (M) indiquant la typologie de défaut liée d'après un signal de commande de lecture reçu ayant soit une première valeur, soit une deuxième valeur, respectivement, dans lequel ladite comparaison comprend le fait d'appliquer aux adresses comparées :
le masque (M) stocké dans les registres de mode de redondance (RMR) lorsque le signal de commande reçu a ladite première valeur ;
ou
le masque (M) stocké dans le registre de mode de redondance de mémoire (GRMR) lorsque le signal de commande reçu a ladite deuxième valeur.

2. Procédé selon la revendication 1, dans lequel un ensemble de registres de redondance dans la pluralité de registres de redondance (ERR) est couplé à un même registre de mode de redondance respectif (RMR) ;
dans lequel une adresse de mémoire défectueuse (A) stockée dans un registre de redondance (ERR) compris dans l'ensemble est couplée à un masque (M) indiquant la typologie de défaut liée stocké dans ledit même registre de mode de redondance respectif (RMR).

3. Procédé selon la revendication 1 ou 2, dans lequel lesdits masques respectifs (M) indiquant une typologie de défaut liée comprennent au moins un premier masque (M) indiquant une première typologie de défaut liée et au moins un deuxième masque (M) indiquant une deuxième typologie de défaut liée, dans lequel le premier masque (M) et le deuxième masque (M) sont stockés dans un premier registre de mode de redondance (RMRₐ) et dans un deuxième registre de mode de redondance (RMR_{b}), le premier masque (M) et le deuxième masque (M) étant égaux ou différents l'un de l'autre.

4. Procédé selon l'une quelconque des revendications précédentes, dans lequel ladite comparaison d'adresses de sous-sections de mémoire (ADDR) de la section de mémoire adressable (AC_{1-N,a-i}) du dispositif MNV candidates pour l'accès avec ledit ensemble d'adresses de sous-sections de mémoire défectueuses comprend le fait de déclarer une correspondance (Red_Act) grâce à l'identité des adresses comparées lorsque les adresses que l'on compare présentent une égalité bit à bit (COMP).

5. Procédé selon l'une quelconque des revendications précédentes, dans lequel ladite comparaison d'adresses de sous-sections de mémoire (ADDR) de la section de mémoire adressable (AC_{1-N,a-i}) du dispositif MNV candidates pour l'accès avec ledit ensemble d'adresses de sous-sections de mémoire défectueuses comprend le fait de déclarer une correspondance grâce à l'identité des adresses comparées auxquelles on a appliqué un masquage d'adresse avec ledit masque (M) indiquant la typologie de défaut liée lorsque les adresses que l'on compare présentent une égalité bit à bit (COMP) des bits qui restent non masqués par ledit masque (M).

6. Procédé selon l'une quelconque des revendications précédentes, dans lequel ledit dispositif de mémoire non volatile, ou MNV, est un dispositif de mémoire à changement de phase, ou PCM.

7. Dispositif de mémoire non volatile, ou MNV, de préférence un dispositif de mémoire à changement de phase, le dispositif MNV comprenant une section de mémoire adressable (AC_{1-N,a-i}) et une section de mémoire de réserve (AC_{red,a-i}) comportant des sous-sections de mémoire de réserve configurées pour substituer (104_{red}, 102_{1-N}) des sous-sections de mémoire défectueuses respectives dans la section de mémoire adressable (AC_{1-N,a-i}) du dispositif MNV ;
dans lequel le dispositif comprend une logique de redondance (100) configurée pour comparer des adresses de sous-sections de mémoire (ADDR) de la section de mémoire adressable (AC_{1-N,a-i}) du dispositif MNV candidates pour l'accès avec un ensemble d'adresses de sous-sections de mémoire défectueuses et pour substituer (104_{red}, 102_{1-N}) avec une sous-section de mémoire de réserve de la section de mémoire de réserve (AC_{red,a-i}) des sous-sections de mémoire (ADDR) de la section de mémoire adressable (AC_{1-N,a-i}) avec le procédé de l'une quelconque des revendications 1 à 6.

8. Produit de programme informatique pouvant être chargé dans une unité de commande d'un dispositif de mémoire non volatile, ou MNV, de préférence un dispositif de mémoire à changement de phase, le dispositif MNV comprenant une section de mémoire adressable (AC_{1-N,a-i}) et une section de mémoire de réserve (AC_{red,a-i}) comportant des sous-sections de mémoire de réserve configurées pour substituer (104_{red}, 102_{1-N}) des sous-sections de mémoire défectueuses respectives dans la section de mémoire adressable (AC_{1-N,a-i}) du dispositif MNV ;
le produit de programme informatique comprenant des parties de code logiciel configurées pour faire mettre en œuvre par le dispositif MNV le procédé de l'une quelconque des revendications 1 à 6 lorsque le produit de programme informatique est exécuté dans l'unité de commande du dispositif MNV.
